# EUROPÄISCHE PATENTSCHRIFT

(11) **EP 2 412 135 B1**
(45) Veröffentlichungstag und Bekanntmachung des Hinweises auf die Patenterteilung: **10.07.2013**
(21) Anmeldenummer: 10713873.7
(22) Anmeldetag: 23.03.2010
(51) Int. Cl.: H04L 25/02

(54) **VERFAHREN UND SCHALTUNG ZUR SIGNALÜBERTRAGUNG ÜBER EINE STROMSCHLEIFE**
METHOD AND CIRCUIT FOR SIGNAL TRANSMISSION VIA A CURRENT LOOP
PROCÉDÉ ET CIRCUIT DE TRANSFERT DE SIGNAUX PAR L'INTERMÉDIAIRE D'UNE BOUCLE DE COURANT

(30) Priorität: 25.03.2009 DE 102009001863; 21.12.2009 DE 102009055111
(43) Veröffentlichungstag der Anmeldung: 01.02.2012
(73) Patentinhaber: Endress+Hauser Conducta Gesellschaft für Mess- und Regeltechnik mbH & Co. KG, 70839 Gerlingen (DE)
(72) Erfinder: HAASE, Björn, 70184 Stuttgart (DE); MARINGER, Bernd, 71701 Schwieberdingen (DE)
(74) Vertreter: Andres, Angelika Maria
(86) Internationale Anmeldenummer: PCT/EP2010/053787
(87) Internationale Veröffentlichungsnummer: WO 2010/108924

(56) Entgegenhaltungen:
- US-A- 6 137 827
- US-A1- 2005 242 979
- PRATT JR W A: "REMOTE MONITORING USING HART PROTOCOL", ADVANCES IN INSTRUMENTATION AND CONTROL, INSTRUMENT SOCIETY OF AMERICA, RESEARCH TRIANGLE PARK, US, Bd. 50, Nr. PART 03, 1. Oktober 1995 (1995-10-01), Seiten 993-1001, XP000540071, ISSN: 1054-0032

## Beschreibung

Die Erfindung bezieht sich auf ein Verfahren zur Signalübertragung zwischen einem ersten und einem zweiten System, wobei das erste und das zweite System über eine Stromschleife miteinander in Verbindung stehen, wobei ein Gleichstromsignal in einem ersten Frequenzbereich und ein Wechselstromsignal in einem zweiten Frequenzbereich über die Stromschleife übertragen werden, wobei sich das Gleichstromsignal und das Wechselstromsignal überlagern, wobei das Wechselstromsignal zur digitalen Signalübertragung und das Gleichstromsignal zur analogen Signalübertragung verwendet werden.

Weiterhin bezieht sich die Erfindung auf eine elektrisch und/oder elektronische Schaltung zur Signalübertragung zwischen einem ersten und einem zweiten System, wobei das erste und das zweite System über eine Stromschleife miteinander in Verbindung stehen, wobei die Stromschleife dazu dient, in einem ersten Frequenzbereich ein Gleichstromsignal und in einem zweiten Frequenzbereich ein Wechselstromsignal zu übertragen, wobei sich das Wechselstromsignal und das Gleichstromsignal überlagern, wobei das Gleichstromsignal zur analogen Signalübertragung und das Wechselstromsignal zur digitalen Signalübertragung dient.

In der Prozessautomatisierungsindustrie werden vielfach Feldgeräte eingesetzt, die zur Erfassung und/oder Beeinflussung von Prozessvariablen dienen. Beispiele für derartige Feldgeräte sind Füllstandmessgeräte, Druck- und Temperaturmessgeräte, pH-Messgeräte, Leitfähigkeitsmessgeräte, Ventilsteuerungen usw., welche als Sensoren oder Aktoren Prozessvariablen wie Füllstand, Durchfluss, Druck, Temperatur, pH-Wert oder Leitfähigkeit erfassen oder steuern.

Eine Vielzahl solcher Feldgeräte wird von der Firma Endress + Hauser © hergestellt und vertrieben.

Häufig sind Feldgeräte mit übergeordneten Einheiten, z.B. Prozessleitsystemen oder Steuerungen verbunden. Diese übergeordneten Einheiten dienen zur Prozessüberwachung, Prozesssteuerung oder Prozessvisualisierung.

Die Signalübertragung zwischen Feldgeräten und übergeordneten Einheiten erfolgt häufig nach dem 4 bis 20 mA Standard über eine Zweileiter-Stromschleife. Handelt es sich bei den Feldgeräten um Sensoren, so werden die von ihnen erfassten Messwerte als Gleichstromsignal über die Zweileiter-Stromschleife an die übergeordneten Einheiten übertragen. Der Messbereich der Sensoren wird dabei linear auf einen 4 bis 20 mA Gleichstrom abgebildet. Normalerweise wird dieses Gleichstromsignal nicht in der übergeordneten Einheit sondern in einem getrennten Messumformerspeisegerät, welches mit der Zweileiter-Stromschleife verbunden ist, erzeugt. Intelligente Feldgeräte besitzen teilweise umfangreiche Diagnose- oder Konfigurationsmoglichkeiten, die z.B. Informationen über den Wartungszustand von Sensoren betreffen, Parametrierungen der Messbereiche ermöglichen oder den Anwender auf baldigen Ausfall des Gerätes hinweisen.

Derartige Diagnoseinformationen können nicht auf einfache Weise in einem 4 bis 20 mA Gleichstromsignal kodiert werden. Eine Lösung, welche ermöglicht, derartige Diagnose oder Konfigurationsmöglichkeiten, bei Beibehaltung der physikalischen Zweileiter-Stromschleifen-Verdrahtung, zu erschließen, besteht in der Nutzung einer digitalen Kommunikation. Ein verbreiteter Standard für die digitale Kommunikation über eine Zweileiter-Stromschleife ist der sogenannte "HART" Standard (Akronym für "Highway Addressable Remote Transducer").

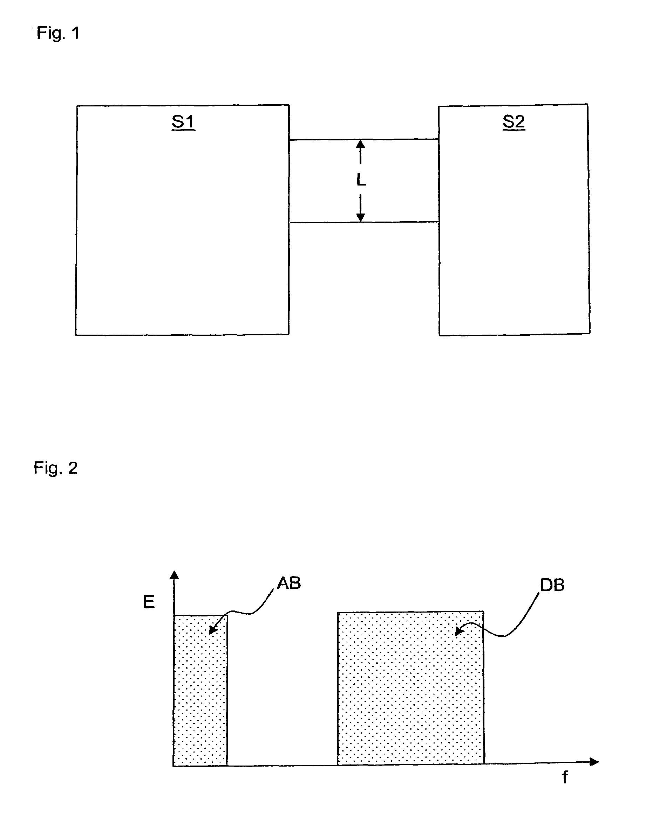

Bei diesem Standard wird die Signalübertragung über die Stromschleife in einem Frequenz F-Multiplex-Betrieb betrieben (siehe auch Figur 2). Im Frequenzband unter 30 Hz, dem so genannten "Analogband", wird die Messgröße analog über ein Gleichstromsignal zwischen 4 und 20 mA kodiert. Damit ist die Kompatibilität mit bestehenden reinen Analogsensoren ohne Diagnose- oder Wartungsfunktionalität gewahrt. Das Frequenzband zwischen 100 Hz und rund 10 kHz wird für die Übertragung digitaler Daten genutzt. Diese Frequenzen werden durch ein das Gleichstromsignal überlagerndes Wechselstromsignal erreicht. Zwei Standards für die Nutzung dieses Frequenzbandes sind verbreitet: Bell 202 mit einer Baudrate von 1200 Hz und eine PSK-Modulation mit einer Baudrate von 4800 Hz. Die PSK-Modulation wird aufgrund von der höheren technischen Schwierigkeit bei der Modulation und Demodulation trotz der höheren physikalischen Übertragungsrate heute vielfach nicht eingesetzt.

Für den Einsatz von Feldgeräten in einem explosionsgefährdeten Bereich, in dem Vorkehrungen gegen Zündfunken zwingend sind, sind Maßnahmen im Hinblick auf die Betriebssicherheit erforderlich. Eine Maßnahme zur Gewährleistung der Betriebssicherheit besteht darin, die elektrischen Schaltungen im Messaufnehmer oder Messumformer galvanisch zu trennen.

Den Vorteilen einer galvanischen Trennung steht ein erhöhter Schaltungsaufwand entgegen. Insbesondere ist es erforderlich, die Messgröße vom Messaufnehmer über die galvanische Barriere in die Stromschleife, welche mit der übergeordneten Einheit galvanisch gekoppelt ist, zu übertragen. Für diese Übertragung sind aus dem Stand der Technik z.B. aus der US2005/0242979A1 bereits Vorrichtungen bekannt.

Den Vorteilen der galvanischen Barriere steht entgegen, dass diese auch für Diagnoseinformationen ein Hindernis bildet. So kann z.B. ein in der Stromschleife auftretender Fehler nicht mehr ohne weiteres mit dem Feldgerät kommuniziert werden. Soll z.B. der in der Stromschleife fließende Strom von der Elektronik des Feldgerätes überwacht werden, ist es erforderlich, Vorrichtungen zur Übertragung einer Kontrollgröße über die galvanische Barriere vorzusehen, welche Rückschlüsse auf den tatsächlich in der Stromschleife fließenden Strom gestattet. Derartige Kontrollfunktionen sind insbesondere für sicherheitskritische Anwendungen von hoher Bedeutung, bei denen das Heldgerat Fehlfunktionen erkennen muss. Solche Kontrollfunktionen werden unter anderem durch Normen wie SIL2 (Akronym für Safety Integrity Level 2") für sicherheitskritische Anwendungen vorgeschrieben.

Werden zwischen galvanisch getrennten Bereichen analoge Messsignale übertragen, so können diese durch Alterung der Kopplungselemente verfälscht werden. Aus diesem Grund ist es vorteilhaft, ausschließlich digitale Signale zwischen den galvanisch getrennten Bereichen zu übertragen. Die durch die galvanische Trennung verursachten Kosten steigen mit der Anzahl der dafür benötigten Leitungen. Eine Minimierung der Anzahl der die galvanische von einander getrennten Bereiche verbindenden Leitungen ist daher anzustreben.

Der Erfindung liegt die Aufgabe zugrunde, eine einfachere Signalübertragung vorzuschlagen.

Die Aufgabe wird hinsichtlich des Verfahrens erfindungsgemäß dadurch gelöst, dass mittels einer Steuereinheit ein erster Datenstrom erzeugt wird, in welchem das in der Stromschleife einzustellende Gleichstromsignal und Wechselstromsignal digital verschlüsselt sind, dass der erste Datenstrom an eine Stromausgangsschaltung übermittelt wird, dass der übermittelte erste Datenstrom von der Stromausgangsschaltung in eine Stromsignal umgesetzt wird, welches Stromsignal aus dem sich überlagernden Gleichstromsignal und Wechselstromsignal besteht, oder dass der übermittelte erste Datenstrom von der Stromausgangsschaltung in das Gleichstromsignal und das Wechselstromsignal umgesetzt wird, und dass das Stromsignal bzw. das Gleichstromsignal und das Wechselstromsignal in der Stromschleife eingestellt werden.

Bei dem ersten System kann es sich, wie bereits erwähnt, um ein Feldgerät der Prozessautomatisierungstechnik handeln. Ein solches Feldgerät ist oftmals über eine Stromschleife, insbesondere über eine Zweileiter-Stromschleife, mit einem zweiten System, bspw. einer übergeordneten Einheit, etwa einem Leitsystem oder einer Prozesssteuerung, verbunden. Über die Stromschleife kann ein Gleichstromsignal, das bspw. einen von einem Messaufnehmer/Sensor Sensor aufgenommenen Messwert repräsentiert und ein Wechselstromsignal, das bspw. anderweitige prozessrelevante Daten wie bspw. Parametereinstellungen enthält, von dem ersten System an das zweite System, oder umgekehrt, übertragen werden. Das Gleichstromsignal und das Wechselstromsignal überlagern sich in der Stromschleife und das resultierende in der Stromschleife eingestellte Stromsignal ist ein Mischstrom mit einem Gleichstromanteil und einem Wechselstromanteil. Mittels der Steuereinheit, die bspw. dem ersten System angehören kann, und der Stromausgangsschaltung, die bspw. ebenfalls dem ersten System angehören kann, können das Gleichstromsignal und das Wechselstromsignal erzeugt und in der Stromschleife eingestellt werden. Der erste Datenstrom kann bspw. mittels der Steuereinheit erzeugt und ausgegeben werden. Bei der Steuereinheit kann es sich um ein digitales, insbesondere programmgesteuertes, Rechenwerk handeln. Eine solche Steuereinheit, bspw. eine Central Processing Unit oder ein Field Programmable Gate Array, ist oftmals ohnehin in einem Feldgerät vorhanden, um eine Funktionalität des Feldgerätes zu gewährleisten - insbesondere um eine Kommunikation mit dem Feldgerat zu ermöglichen. Die Steuereinheit kann auch aus mehreren Komponenten, wie z.B. einem Rechenwerk und einem daran angeschlossenen Register oder weiteren elektrischen und/oder elektronischen Bauteilen bestehen.

In dem ersten Datenstrom sind das in der Stromschleife einzustellende Gleichstromsignal und Wechselstromsignal digital, vorzugsweise binär, verschlüsselt. Der erste Datenstrom kann bspw. aus einer Folge von Bits, einem sog. Bitstream, zu Deutsch Bitstrom, bestehen. Die in dem ersten Datenstrom verschlüsselte Information weist bspw. eine zeitlich geordnete Reihenfolge auf und kann fortlaufend erzeugt und weiterverarbeitet werden. Überdies besteht die Möglichkeit, den ersten Datenstrom sequentiell zu verarbeiten. Die Stromausgangsschaltung dient bspw. dazu, den übermittelten ersten Datenstrom in das Gleichstromsignal und das Wechselstromsignal umsetzen. Der erste Datenstrom kann bspw. unmittelbar von der Stromausgangsschaltung in das in der Stromschleife einzustellende Stromsignal umgesetzt werden, welches Stromsignal aus dem sich überlagernden Gleichstromsignal und Wechselstromsignal besteht. Alternativ besteht die Möglichkeit einen Anteil des ersten Datenstroms, der das Gleichstromsignal (in digital verschlüsselter Form) enthält, von einem anderen Anteil des ersten Datenstroms zu trennen, der das Wechselstromsignal (in digital verschlüsselter Form) enthält, und den Anteil, der das Gleichstromsignal enthält, getrennt von dem anderen Anteil, der das Wechselstromsignal enthält, in das analoge Gleichstromsignal bzw. das analoge Wechselstromsignal umzusetzen. Anschliessend kann das Wechselstromsignal auf das Gleichstromsignal gekoppelt und in der Stromschleife eingestellt werden.

Mithilfe des ersten Datenstroms, der das in der Stromschleife einzustellende Wechselstromsignal und Gleichstromsignal in digital verschlüsselter Form enthält, können die beiden Signale nunmehr über eine einzige Signalleitung bzw. Datenleitung an die Stromausgangsschaltung übermittelt werden. Daraus ergibt sich der Vorteil, dass eine solche Übermittlung mit einer geringen Anzahl von elektrischen und/oder elektronischen Bauteilen realisiert werden kann und dadurch die Signalübertragung zwischen dem ersten und dem zweiten System als auch die Übermittlung von Signalen zwischen der Steuereinheit und der Stromausgangsschaltung vereinfacht wird.

In einer Ausgestaltung des Verfahrens wird wenigstens ein Steuersignal von der Steuereinheit erzeugt, in welchem das in der Stromschleife einzustellende Wechselstromsignal und Gleichstromsignal digital verschlüsselt wird. Der erste Datenstrom kann bspw. aus dem von der Steuereinheit erzeugten Steuersignal gebildet werden oder das Steuersignal kann in den ersten Datenstrom zusammengefasst und/oder umgewandelt werden. Der Datenstrom kann bspw. aus dem Steuersignal bestehen, wobei das Steuersignal das einzustellende Gleichstromsignal und Wechselstromsignal in digital verschlüsselter Form enthält. Hilfsweise kann der erste Datenstrom mittels des von der Steuereinheit erzeugt Steuersignals erzeugt, bzw. daraus abgeleitet, werden. In einer Variante wird das wenigstens eine Steuersignal von der Steuereinheit an eine elektrische und/oder elektronische Hilfseinheit gesendet, die aus dem Steuersignal den ersten Datenstrom ableitet und/oder erzeugt. Von der Steuereinheit können insbesondere auch mehrere Steuersignale erzeugt werden, die zur Erzeugung des ersten Datenstroms dienen.

In einer anderen Ausgestaltung des Verfahrens wird wenigstens ein erstes Steuersignal von der Steuereinheit erzeugt, in welchem das in der Stromschleife einzustellende Wechselstromsignal digital verschlüsselt wird und wenigstens ein zweites Steuersignal wird von der Steuereinheit erzeugt, in welchem das in der Stromschleife einzustellende Gleichstromsignal digital verschlüsselt wird. Das erste und das zweite Steuersignal können zusammengefasst und/oder in den ersten Datenstrom umgewandelt werden. Dadurch kann die zur Signalübertragung benötigte Hardware reduziert werden. Weiterhin können dadurch das Gleichstromsignal und das Wechselstromsignal unabhängig voneinander erzeugt werden.

In einer weiteren Ausgestaltung wird mittels des ersten Steuersignals mindestens ein Zahlenwert erzeugt, der dem einzustellenden Wechselstromsignal entspricht. Der Zahlenwert kann insbesondere zeitlich veränderlich sein und diese zeitliche Veränderung kann dem einzustellenden Wechselstromsignal entsprechen. Das Wechselstromsignal kann wie bereits erwähnt, im Fall des HART-Standards sinusförmig sein, so dass bspw. durch eine FSK-Modulation digitale Daten übertragen werden können. Dieses sinusförmige Signal, auch Sinussignal bezeichnet, kann durch den wenigstens einen Zahlenwert approximiert werden.

In einer weiteren Ausgestaltung wird mittels des ersten Steuersignals eine Folge von Zahlenwerten erzeugt, wobei die Folge dem einzustellenden Wechselstromsignal entspricht. In der Folge der Zahlenwerte kann ein Sinussignal, insbesondere ein Frequenzmoduliertes, auch als FSK-Modulation bezeichnet, Sinussignal verschlüsselt sein, welches dem einzustellenden Wechselstromsignal entspricht. Durch die Folge von diskreten Zahlenwerten kann das Sinussignal approximiert werden. Zur Erzeugung des wenigstens einen Zahlenwerts oder der Folge von Zahlenwerten kann bspw. eine digitale Schalteinheit verwendet werden.

In einer weiteren Ausgestaltung werden der Zahlenwert bzw. einzelne Zahlenwerte der Folge in einem Format mit einer Bitbreite von n Bits erzeugt, wobei n eine natürliche Zahl, insbesondere drei oder vier, ist. Es hat sich als vorteilhaft erwiesen, die Zahlenwerte in einem Format mit einer Bitbreite von n Bits darzustellen und zu verarbeiten. Dabei kann die Bitbreite n im Grunde beliebig gewählt werden. Zur Minimierung des Rechenaufwands bei der Verarbeitung der Zahlenwerte, hat es sich aber als vorteilhaft erwiesen, n möglichst klein zu wählen. Dabei kann die Bitbreite n bspw. kleiner 100, bevorzugt kleiner 50 und besonders bevorzugt kleiner 25 sein. Weiterhin kann die Bitbreite kleiner 10 gewählt werden. In diesem Zusammenhang hat es sich als vorteilhaft erwiesen, das einzustellende Wechselstromsignal durch Zahlenwerte mit einer Bitbreite von 3 Bits oder in einem anderen Fall mit 4 Bits zu erzeugen. Das aus einem Zahlenwert bzw. einer Folge von Zahlenwerten abgeleitete und in der Stromschleife eingestellte Wechselstromsignal weist dabei Oberschwingungen erst ab einer hinreichend hohen Ordnung auf, so dass das in der Stromschleite eingestellte Wechselstromsignal eine ausreichende Signalgüte aufweist.

In einer weiteren Ausgestaltung des Verfahrens wird mittels des zweiten Steuersignals ein dem einzustellenden Gleichstromsignal entsprechender Zahlenwert, insbesondere mit einer Bitbreite von weniger als m Bits, erzeugt, wobei m eine natürliche Zahl ist. Die Bitbreite kann dafür insbesondere kleiner 24 Bits gewählt werden. Das erste und das zweite Steuersignal können zur Verarbeitung in vorteilhafter Weise in einem Format mit einer vorgegebenen Bitbreite erzeugt werden bzw. vorliegen.

In einer Ausgestaltung des Verfahrens wird mindestens ein Zahlenwert der Folge, welcher das Wechselstromsignal repräsentiert, insbesondere auf die Bitbreite des Zahlenwerts des Gleichstromsignals, skaliert. Zur Verarbeitung der beiden Zahlenwerte können diese auf dieselbe Bitbreite gebracht werden. Dabei kann es erforderlich sein den wenigstens einen Zahlenwert bzw. die Folge von Zahlenwerten, welche das einzustellende Wechselstromsignal repräsentieren auf die Bitbreite des Zahlenwerts zu skalieren, welcher das einzustellende Gleichstromsignal repräsentiert. Das Skalieren kann dabei insbesondere durch Schieben der Bits, die den Zahlenwert des einzustellenden Wechselstromsignals bilden, erfolgen.

In einer Ausführungsform des Verfahrens werden wenigstens ein Zahlenwert der Folge, welche das Wechselstromsignal repräsentiert und der Zahlenwert des einzustellenden Gleichstromsignals zusammengefasst, insbesondere addiert, und in den ersten Datenstrom umgesetzt. Dadurch können Daten bzw. Signale - und in der Folge auch der erste Datenstrom - erzeugt werden, die sowohl das einzustellende Gleichstromsignal als auch das einzustellende Wechselstromsignal enthalten.

In einer weiteren Ausführungsform des Verfahrens wird die Umsetzung mittels eines digitalen Delta-Sigma-Modulators durchgeführt, wobei der digitale Delta-Sigma-Modulator abhängig von einem Eingangswert betrieben wird, wobei der Eingangswert von dem einzustellenden Gleichstromsignal und/oder Wechselstromsignal abhängig ist, wobei der Eingangswert insbesondere aus wenigstens einem Zahlenwert der Folge, die dem einzustellenden Wechselstromsignal entspricht und/oder dem Zahlenwert des einzustellenden Gleichstromsignals abgeleitet wird, in erster oder zweiter Ordnung betrieben wird. Das erste und das zweite Steuersignal können in den ersten Datenstrom umgesetzt werden. Dafür kann ein digitaler Delta-Sigma-Modulator verwendet werden, der bspw. mittels einer geeigneten Schaltungseinheit in erster oder zweiter Ordnung betrieben wird. Alternativ ist es möglich das erste und das zweite Steuersignal mittels eines digitalen Delta-Sigma-Modulators erster Ordnung oder zweiter Ordnung zu erzeugen. Der Eingangswert kann natürlich auch direkt aus dem ersten und/oder Steuersignal abgeleitet werden.

In einer Ausgestaltung des Verfahrens kann zwischen einem digitalen Delta-Sigma-Modulator erster Ordnung und einem digitalen Delta-Sigma-Modulator zweiter Ordnung umgeschaltet werden. Der Vorteil dieser Umschaltung zwischen erster und zweiter Ordnung besteht darin, dass Modulatoren 2. Ordnung zwar das Quantisierungsrauschen besser unterdrücken können, jedoch für die dafür Verwendeten inneren Summations-Akkumulatoren, d.h. digitalen Speicher, sehr große Bitbreiten benötigen, wenn der Aussteuerbereich vom unteren bis zum oberen Limit voll ausgenutzt werden soll. Dadurch, dass zwischen einem Delta-Sigma-Modulator erster und/oder zweiter Ordnung umgeschaltet wird, kann der Bedarf an kombinatorischen Logikgattern und an Flipflops in der verwendeten Schaltung stark reduziert werden und damit die Kosten der Digitalschaltung, ohne dass die Möglichkeit verloren geht, den vollen Aussteuerbereich zu nutzen. Zur Umschaltung kann dann bspw. der bereits erwähnte Eingangswert verwendet werden, der aus dem ersten und/oder zweiten Steuersignal abgeleitet bzw. aus wenigstens einem Zahlenwerten insbesondere aus der Folge von Zahlenwerten, welcher dem einzustellenden Wechselstromsignal entspricht, und/oder einem Zahlenwert des einzustellenden Gleichstromsignals abgeleitet werden.

In einer Weiterbildung des Verfahrens werden das in der Stromschleife eingestellte Gleichstromsignal und Wechselstromsignal in einen zweiten Datenstrom umgewandelt, in welchem zweiten Datenstrom das Gleichstromsignal und das Wechselstromsignal digital verschlüsselt werden, und der zweite Datenstrom wird von der Stromausgangsschaltung an die Steuereinheit rückübermittelt. Das in der Stromschleife eingestellte Stromsignal bzw. Gleichstromsignal und Wechselstromsignal können zu Überwachungszwecken zurückgelesen werden. Dadurch kann die Funktion der Steuereinheit und der Stromausgangsschaltung überwacht werden. Dies wird in einfacher Weise durch die vorgeschlagene Weiterbildung erreicht, indem für die Rückübermittlung der zweite Datenstrom erzeugt wird, der das in der Stromschleife eingestellte Gleichstromsignal und das Wechselstromsignal in digital, insbesondere binär, verschlüsselter Form enthält. Die in dem zweiten Datenstrom enthaltenen Anteile des Gleichstromsignals und des Wechselstromsignals können in einfacher Weise voneinander getrennt und überprüft werden. Zudem kann aufgrund des digitalen Charakters des ersten und des zweiten Datenstroms zur Erzeugung und zum Empfang des ersten und des zweiten Datenstroms bspw. eine Steuereinheit mit ausschließlich digitalen Ein- /Ausgängen oder zur Erzeugung bzw. zum Empfang des ersten und zweiten Datenstroms ausschließlich digitale Eingänge und Ausgänge der Steuereinheit verwendete werden.

In einer Fortbildung des Verfahrens wird das in der Stromschleife eingestellte und sich überlagernde Gleichstrom- und Wechselstromsignal abgetastet und in einen zweiten Datenstrom umgewandelt.

In einer weiteren Fortbildung des Verfahrens wird die Abtastrate des zweiten Datenstroms, insbesondere mittels eines Dezimationsfilters, verringert.

In einer Fortbildung des Verfahrens wird aus dem, insbesondere dezimierten, zweiten Datenstrom ein erster Zahlenwert ermittelt, der das in der Stromschleife eingestellte Gleichstrom- und Wechselstromsignal repräsentiert.

In einer Fortbildung des Verfahrens wird aus dem ersten Zahlenwert ein zweiter Zahlenwert abgeleitet, der dem in der Stromschleife eingestellten Gleichstromsignal entspricht, und aus dem ersten Zahlenwert wird ein dritter Zahlenwert abgeleitet, der dem in der Stromschleife eingestellten Wechselstromsignal entspricht. Das Auswerten des ersten Zahlenwerts, der insbesondere wieder in einem Format mit einer Bitbreite von p Bits, wobei p eine natürliche Zahl ist, vorliegen kann, kann abhängig davon sein, ob gerade das eingestellte Wechselstromsignal und/oder das eingestellte Gleichstromsignal zurückgelesen und/oder überwacht werden soll. Ebenso wie der erste Zahlenwert können auch der zweite und/oder dritte Zahlenwert in einem Format mit einer Bitbreite von q bzw. r Bits bestehen, wobei q und r natürliche Zahlen sind.

In einer weiteren Fortbildung des Verfahrens wird eine Frequenzgangkorrektur des abgetasteten, insbesondere dezimierten, Gleichstrom- und/oder Wechselstromsignals durchgeführt.

In einer weiteren Ausgestaltung des Verfahrens wird der dritte Zahlenwert in für die Steuereinheit lesbare Signale, insbesondere mittels eines Quadratur Demodulators, umgewandelt bzw. dekodiert und an die Steuereinheit übertragen.

In einer Weiterbildung des Verfahrens werden der erste Datenstrom und/oder der zweite Datenstrom über eine galvanische Barriere übermittelt. Durch die galvanische Barriere wird bspw. ein die Steuereinheit umfassender Primärkreis von einem wenigstens die Stromausgangsschaltung umfassenden Sekundärkreis elektrisch isoliert. Werden zwischen den galvanisch getrennten Bereichen bspw. analoge Signale, insbesondere Messsignale, übertragen, so können diese durch Alterung der Kopplungselemente verfälscht werden. Es ist daher vorteilhaft, ausschließlich digitale Signale zwischen den galvanisch getrennten Systemen zu übertragen.

In einer Weiterbildung des Verfahrens wird mittels der Steuereinheit ein Wert des in der Stromschleife eingestellten und rückübermittelten Gleichstromsignals und/oder Wechselstromsignals mit einem Sollwert verglichen. Im Fehlerfall kann aufgrund der verwendeten digitalen Übermittlung somit zuverlässig ein entsprechendes Fehlersignal von der Steuereinheit ausgegeben werden.

In einer Weiterbildung des Verfahrens ist ein Betriebsmodus vorgesehen, in welchem Betriebsmodus mittels des ersten Datenstroms ein maximaler Wert des in der Stromschleife einstellbaren Gleichstromsignals vorgegeben wird, in welchem Betriebsmodus weiterhin der Wert des Gleichstromsignals in der Stromschleife von einer in dem zweiten System vorgesehenen Einheit auf einen Wert kleiner oder gleich dem maximalen Wert begrenzt wird, und in welchem Betriebsmodus der in der Stromschleife eingestellte Wert des Gleichstromsignals über den zweiten Datenstrom an die Steuereinheit übermittelt wird. Beispielsweise enthält das zweite System als zur Begrenzung des Gleichstromsignals vorgesehene Einheit eine Stromquelle, welche den in der Stromschleife fließenden Strom auf einen Stellwert begrenzt. Das im ersten digitalen Datenstrom übermittelte einzustellende Gleichstromsignal kann dann auf einer; Wert größer als der maximal von dem zweiten System zu erwartende Wert gesetzt werden, so dass der in der Stromschleite flieeßende Strom nicht durch die Stromausgangsschaltung des ersten Systems sondern durch die dafür vorgesehene Einheit des zweiten Systems begrenzt wird. In dem vorgeschlagenen Betriebsmodus enthält der an die Steuereinheit rückübermittelte zweite digitale Datenstrom somit Informationen über den von der zur Begrenzung des Gleichstromsignals vorgesehenen Einheit im zweiten System eingestellten Stellwert des Gleichstromsignals.

In einer weiteren Ausgestaltung des Verfahrens handelt es sich bei dem in der Stromschleife eingestellten Wechselstromsignal um ein im Wesentlichen sinusförmiges Wechselstromsignal, wobei die Oberschwingungen des sinusförmigen Wechselstromsignals bis einschließlich der 6. Ordnung um einen Wert von mindestens 30 dB relativ zur Amplitude der Grundschwingung des sinusförmigen Wechselstromsignals gedämpft werden. Dazu kann bspw. die digitale Schalteinheit, insbesondere der zur Erzeugung des sinusförmigen Wechselstromsignals vorgesehene Schaltungsteil, d.h. der sog. Sinusgenerator, entsprechend ausgelegt sein.

In einer weiteren Ausgestaltung des Verfahrens wird mindestens eine Oberschwingung der 7. Ordnung oder höheren Ordnung um einen Wert von weniger als 30 dB relativ zur Amplitude der Grundschwingung gedämpft. Auch hier kann die Erkenntnis ausgenutzt werden, dass die höheren Oberschwingungen für die Güte des in der Stromschleife erzeugten Sinussignals nicht wesentlich sind, und unter technischer Ausnutzung dieser Erkenntnis digitale Sinusgeneratoren genutzt werden können, welche einen Bruchteil der Gatter benötigen, als Sinusgeneratoren, welche auch Oberwellen größer als 7. Ordnung unterdrücken.

Hinsichtlich der elektrischen und/oder elektronischen Schaltung wird die Aufgabe erfindungsgemäß dadurch gelöst, dass eine Steuereinheit vorgesehen ist, welche zur Erzeugung eines ersten Datenstroms dient, in welchem ersten Datenstrom das in der Stromschleife einzustellende Gleichstromsignal und Wechselstromsignal digital verschlüsselt sind, dass eine erste Übermittlungseinheit vorgesehen ist, welche dazu dient, den ersten Datenstrom an eine Stromausgangsschaltung zu übermitteln, und dass die Stromausgangsschaltung dazu dient, den übermittelten ersten Datenstrom in ein Stromsignal umzusetzen, welches Stromsignal aus dem sich überlagernden Gleichstromsignal und Wechselstromsignal besteht, oder das die Stromausgangsschaltung dazu dient, den übermittelten ersten Datenstrom in das Gleichstromsignal und das Wechselstromsignal umzusetzen.

Mithilfe der Steuereinheit kann ein erster Datenstrom erzeugt werden, in welchem das einzustellende Gleichstromsignal und ein Wechselstrom signal digital verschlüsselt sind. Das Gleichstromsignal kann dabei einem von bspw. einem Messaufnehmer/Sensor Sensor aufgenommenen Messwert und das Wechselstromsignal prozessrelevanten Daten, wie bspw. einem Statussignal für die Wartung oder Parametrierung entsprechen. Insbesondere handelt es sich bei dem Wechselstromsignal um ein gemäß dem HART-Protokoll moduliertes Signal. Zur Übermittlung des Datenstroms ist die Übermittlungseinheit vorgesehen. Die Übermittlungseinheit kann aus einer Kabel-, Draht- oder Wellenleitung oder andersartigen elektrischen und/oder elektromagnetischen, insbesondere optischen, Verbindung bestehen. Von der Stromausgangsschaltung kann der übermittelte erste Datenstrom in das Stromsignal, welches aus dem sich überlagernden Gleichstromsignal und Wechselstromsignal zusammensetzt, umgesetzt werden. Dabei kann das Stromsignal in der Stromschleife eingestellt werden. Ein Vorteil der vorgeschlagenen Schaltung besteht wie bereits erwähnt darin, dass das einzustellende Gleichstromsignal und Wechselstromsignal in einem einzigen Datenstrom, nämlich dem ersten Datenstrom digital verschlüsselt sind.

In einer Ausgestaltung der elektrischen und/oder elektronischen Schaltung wird von der Steuereinheit wenigstens ein digitales Steuersignal erzeugt und/oder ausgegeben, welches zur Erzeugung des Gleichstromsignals und des Wechselstromsignals, insbesondere des ersten Datenstroms, dient. Die Steuereinheit kann ein Steuersignal ausgeben, welches Steuersignal bereits das einzustellende Gleichstromsignal und Wechselstromsignal in digital verschlüsselter Form enthält und den ersten Datenstrom bildet. Der Aufbau der vorgeschlagenen Ausgestaltung ist besonders einfach und kann mit wenigen Bauteilen realisiert werden.

In einer weiteren Ausgestaltung der elektrischen und/oder elektronischen Schaltung gibt die Steuereinheit wenigstens ein erstes digitales Steuersignal aus, welches zur Erzeugung des Gleichstromsignals dient und weiterhin wenigstens ein zweites digitales Steuersignal aus, welches zur Erzeugung des Wechselstromsignals dient. In einer Ausgestaltung der elektrischen und/oder elektronischen Schaltung ist eine erste Signalverarbeitungseinheit vorgesehen, welche dazu dient, das erste und das zweite digitale Steuersignal oder daraus abgeleitete Signale in den ersten Datenstrom zusammenzufassen und/oder umzuwandeln. In dieser Ausgestaltung wird das Zusammenfassen und/oder Umwandeln des ersten und des zweiten Steuersignals in den ersten Datenstrom von der ersten Signalverarbeitungseinheit übernommen. Dadurch können den jeweiligen Anforderungen entsprechende elektrische und/oder elektronische aufeinander abstimmbare Standartbauteile verwendet werden. Die digitalen Steuersignale können bspw. mittels eines Addierwerks, das z.B. Teil der Signalverarbeitungseinheit ist, zusammengefasst werden.

In einer Fortbildung der Schaltung ist eine digitale Schalteinheit vorgesehen, die zur Erzeugung des ersten Datenstroms, insbesondere des in der Stromschleife einzustellenden Wechselstromsignals mittels eines ersten von der Steuereinheit ausgegebenen, insbesondere digitalen, Steuersignals, dient.

In einer weiteren Fortbildung der Schaltung weist die Steuereinheit eine, insbesondere serielle, digitale Kommunikations-Schnittstelle, auf, wobei die digitale Kommunikations-Schnittstelle zur Übertragung von das einzustellende Wechselstromsignal repräsentierenden Steuersignalen zwischen der digitalen Schalteinheit und der Steuereinheit dient.

In einer weiteren Fortbildung der Schaltung dient die digitale Schalteinheit dazu, aus den von der Steuereinheit über die digitale Kommunikations-Schnittstelle übertragenen Steuersignalen, mindestens einen Zahlenwert oder eine Folge von Zahlenwerten zu erzeugen, welcher Zahlenwert bzw. welche Folge dem in der Stromschleife einzustellenden Wechselstromsignal entspricht, wobei die Zahlenwerte insbesondere in einem Format mit einer Bitbreite von n bit dargestellt sind.

In einer weiteren Fortbildung der Schaltung ist ein Register vorgesehen, welches von der Steuereinheit, insbesondere mittels eines zweiten, insbesondere digitalen, Steuersignals, ansteuerbar ist und dazu dient, einen dem einzustellenden Gleichstromsignal entsprechenden Zahlenwert auszugeben, wobei der Zahlenwert in einem Format mit einer Bitbreite von m bit dargestellt ist.

In einer weiteren Ausgestaltung der elektrischen und/oder elektronischen Schaltung umfasst die erste Signalverarbeitungseinheit einen digitalen Delta-Sigma-Modulator, der dazu dient, den ersten Datenstrom zu erzeugen. Der digitale Delta-Sigma-Modulator wandelt ein eingangsseitig anliegendes digitales Signal ausgangsseitig in ein ebenfalls digitales Signal um. Eingangsseitig kann dem digitalen Delta-Sigma-Modulator das mindestens eine Steuersignal oder das zusammengefasste erste und zweite Steuersignal zugeführt werden. Der ausgangsseitig ausgegebene erste Datenstrom kann bspw. aus einem sog. Bitstrom bestehen. Alternativ ist auch die Verwendung eines andersartigen Digital-Digital-Wandlers möglich. Die Funktion der Signalverarbeitungseinheit kann bspw. in die Steuereinheit integriert sein, sodass von der Steuereinheit lediglich der erste Datenstrom ausgegeben wird.

In einer Ausführungsform der Schaltung ist der Sigma-Delta-Modulator (DM) so ausgestaltet, dass der Sigma-Delta-Modulator (DM) in Abhängigkeit eines Eingangswerts, welcher aus dem in der Stromschleife einzustellenden Wechselstromsignal und Gleichstromsignal entspricht ableitbar ist, in erster oder zweiter Ordnung betreibbar ist.

In einer weiteren Ausgestaltung der elektrischen und/oder elektronischen Schaltung ist eine Synchronisierungseinheit vorgesehen, die dazu dient, den übermittelten ersten Datenstrom mit einem vorgegebenen Takt zu synchronisieren. Die Synchronisierungseinheit kann bspw. aus einem Flip-Flop, insbesondere einem D-Flip-Flop, bestehen und den an die Stromausgangsschaltung übermittelten ersten Datenstrom mit einem vorgegebenen Takt synchronisieren. Dadurch wird ein von Jitter ansatzweise befreites Signal erzeugt.

In einer weiteren Ausgestaltung der elektrischen und/oder elektronischen Schaltung weist die Stromausgangsschaltung einen ersten Filter mit einer Tiefpasscharakteristik auf, welcher den übermittelten ersten Datenstrom in eine analoge Spannung verarbeitet. Um den Frequenzbereich des Wechselstromsignals nicht zu begrenzen, kann die Grenzfrequenz des Tiefpassfilters höher gewählt werden, als die Frequenz des in der Stromschleife einzustellenden Wechselstromsignals. Der Frequenzbereich des Wechselstromsignals wird dann nicht durch den Tiefpassfilter unterdruckt - vielmehr wird lediglich Rauschen unterdrückt, welches von Frequenzen herrührt, welche größer sind als die des Wechselstromsignals.

In einer weiteren Ausgestaltung der elektrischen und/oder elektronischen Schaltung umfasst die Stromausgangsschaltung einen Spannungs-Strom-Wandler, welcher zur Umsetzung der analogen Spannung in das Gleichstromsignal und das Wechselstromsignal dient. Mittels des Spannungs-Strom-Wandlers kann das als Spannungssignal vom Tiefpassfilter ausgegebene Ausgangssignal in das in der Zweileiter-Stromschleife einzustellende Stromsignal umgesetzt werden.

In einer weiteren Ausgestaltung der elektrischen und/oder elektronischen Schaltung sind elektrische und/oder elektronische Bauteile der Stromausgangsschaltung räumlich von elektrischen Leiterbahnen umgeben, welche Leiterbahnen aktiv auf dem im Wesentlichen gleichen Gleichspannungspotential gehalten werden wie die elektrischen und/oder elektronischen Bauteile. Damit kann der Abfluss von Leckströmen effektiv verhindert oder verringert werden. Insbesondere die elektrischen und/oder elektronischen Bauteile z.B. einem RC-Glieds des ersten Filters können dabei von elektrischen Leiterbahnen umgeben sein, welche auf dem im Wesentlichen gleichen Gleichspannungspotential wie die Bauteile selbst gehalten werden, um das Abfließen von Leckströmen zu verhindern und ein unverfälschtes Spannungssignal an den Spannungs-Strom-Wandler weiterzuleiten.

In einer weiteren Ausgestaltung der elektrischen und/oder elektronischen Schaltung weist die Stromausgangschaltung eine zweite Signalverarbeitungseinheit auf, welche das in der Stromschleife eingestellte Gleichstromsignal und/oder Wechselstromsignal in einen zweiten Datenstrom umwandelt, in welchem zweiten Datenstrom das Gleichstromsignal und das Wechselstromsignal digital verschlüsselt sind.

In einer weiteren Ausgestaltung der elektrischen und/oder elektronischen Schaltung weist die zweite Signalverarbeitungseinheit einen analogen Delta-Sigma-Modulator auf, der dazu dient, den zweiten Datenstrom zu erzeugen. Der analoge Delta-Sigma-Modulator kann wandelt ein eingangsseitig anliegendes analoges Signal ausgangsseitig in ein digitales Signal um. Eingangsseitig liegt an dem analogen Delta-Sigma-Modulator dann bspw. das in der Stromschleife eingestellte Stromsignal an, welches ausgangsseitig in einen zweiten Datenstrom umgewandelt wird. Auch hier kann alternativ ein anderweitiger Analog-Digital-Wandler anstelle des analogen Delta-Sigma-Modulators verwendet werden.

In einer weiteren Ausgestaltung der elektrischen und/oder elektronischen Schaltung ist ein für die Modulation verwendetes Schleifenfilter des analogen Delta-Sigma-Modulators ein zeitkontinuierliches Filter. Der zeitkontinuierliche Filter hat bspw. gegenüber einem zeitdiskreten Filter einen größeren Signal/Rausch Abstand. Zudem wird bei einem zeitdiskreten Filter Kein Integrierter Schaltkreis zum Schalten von bspw. Switched Capacitor-Schaltungen benötigt.

In einer weiteren Ausgestaltung der elektrischen und/oder elektronischen Schaltung ist das für die Modulation verwendete Schleifenfilter mittels eines einzigen Operationsverstärkers realisiert, wobei ein Pol der Übertragungsfunktion durch ein RC-Glied realisiert ist. Das zeitkontinuierliche Filter weist wenigstens ein RC-Glied, d.h. ein aus wenigstens einem Widerstand und wenigstens einem Kondensator aufgebautes System, auf, welches einen bei einem zeitdiskreten Filter bspw. zum Schalten der Kondensatoren verwendeten Integrierten Schaltkreis ersetzt. Dies vereinfacht die Schaltung und verringert dadurch die Herstellungskosten des analogen Delta-Sigma-Modulators. Die Polstellen einer solchen Übertragungsfunktion bestimmen maßgeblich das Übertragungsverhalten bspw. des ersten Filters mit Tiefpasscharakteristik.

In einer weiteren Ausgestaltung der elektrischen und/oder elektronischen Schaltung ist eine zweite Übermittlungseinheit vorgesehen, die dazu dient, den zweiten Datenstrom an die Steuereinheit zu übermitteln. Die zweite Übermittlungseinheit kann dabei ebenso wie die erste Übermittlungseinheit aus einer Signal- und/oder Datenleitung bestehen oder bspw. eine Einheit zur Signalübertragung über eine galvanische Barriere sein. Bei der ersten und/oder zweiten Übermittlungseinheit kann es sich insbesondere um einen Optokoppler oder um einen Übertrager handeln.

In einer weiteren Ausgestaltung der elektrischen und/oder elektronischen Schaltung ist ein zweites Filter vorgesehen, welches zweite Filter den über die zweite Übermittlungseinheit übermittelten zweiten Datenstrom in ein erstes dem Gleichstromsignal entsprechendes Signal und in ein zweites dem Wechselstromsignal entsprechendes Signal trennt. Bei dem zweiten Filter kann es sich insbesondere um ein Dezimationsfilter handeln und bei dem ersten Signal und dem zweiten Signal kann es sich um digitale Signale handeln. Dieses erste und zweite Signal können bspw. zu Überwachungszwecken an die Steuereinheit rückübermittelt werden.

In einer weiteren Ausführungsform der Schaltung ist ein Dezimationsfilter, insbesondere CIC-Filter, vorgesehen, der zur Änderung der Abtastrate des zweiten Datenstroms dient.

In einer weiteren Ausführungsform der Schaltung gibt der Dezimationsfilter einen Zahlenwert oder eine Folge von Zahlenwerten aus, der das in der Stromschleife eingestellte Gleichstromsignal und das Wechselstromsignal repräsentiert.

In einer weiteren Ausführungsform der Schaltung ist ein Filter, insbesondere ein Moving Average Filter, vorgesehen, der einen ersten Anteil des Zahlenwerts von einem zweiten Anteil des Zahlenwerts, welcher das in der Stromschleife eingestellte Gleichstromsignal und das Wechselstromsignal repräsentiert, von einander trennt, wobei der erste Anteil dem in der Stromschleife eingestellten Wechselstromsignal entspricht, und wobei der zweite Anteil dem in der Stromschleife eingestellten Gleichstromsignal entspricht.

In einer weiteren Ausführungsform der Schaltung dient das Register ferner dazu, den zweiten Anteil des Zahlenwerts zu verarbeiten.

In einer weiteren Ausführungsform der Schaltung wird der erste Anteil einem Quadratur-Demodulator zugeführt, welcher für die Steuereinheit lesbare Signale, insbesondere ein RxD und ein Carrier Detect Signal, erzeugt.

In einer weiteren Ausführungsform der Schaltung sind das RxD Signal und das Carrier Detect Signal über die digitalen Kommunikations-Schnittstelle UART der Steuereinheit zuführbar sind.

In einer weiteren Ausführungsform der Schaltung handelt es sich bei dem in der Stromschleife eingestellten Wechselstromsignal um ein im Wesentlichen sinusförmiges Wechselstromsignal, wobei die Oberschwingungen des sinusförmigen Wechselstromsignals bis einschließlich der 6. Ordnung um einen Wert von mindestens 30 dB relativ zur Amplitude der Grundschwingung des sinusförmigen Wechselstromsignals gedämpft sind. In einer weiteren Ausführungsform der Schaltung sind mindestens eine Oberschwingung der 7. Ordnung oder höheren Ordnung um einen Wert von weniger als 30 dB relativ zur Amplitude der Grundschwingung gedämpft.

Eine weitere Ausgestaltung der Erfindung betrifft ein Feldgerät der Prozess- und/oder Automatisierungstechnik mit einer elektrischen und/oder elektronischen Schaltung in einer der vorgenannten Ausgestaltungen. Insbesondere Feldgeräte, die zur Erfassung und/oder Steuerung von Prozessvariablen dienen, kommunizieren über eine Stromschleife mit einem zweiten System, insbesondere einer übergeordneten Einheit. Die erfindungsgemäße Schaltung ermöglicht ebenso eine zuverlässigere Signalübermittlung über die galvanische Barriere sowie eine einfachere Signalübertragung über die Stromschleife. Zudem wird die Diagnose der Feldgeräteelektronik, d.h. der Steuereinheit und der Stromausgangsschaltung erleichtert.

Die Erfindung wird anhand der nachfolgenden Zeichnungen näher erläutert. Es zeigt:
Fig. 1: eine schematische Darstellung eines ersten Systems, das über eine Stromschleife mit einem zweiten System verbunden ist,
Fig. 2: eine schematische Darstellung des Frequenzspektrums des in der Stromschleife einstellbaren Stromsignals,
Fig. 3: eine schematische Darstellung der Steuereinheit und der Stromausgangsschaltung aus dem Stand der Technik,
Fig. 4: eine schematische Darstellung einer Ausführungsform einer erfindungsgemäßen Schaltung,
Fig. 5: eine schematische Darstellung einer weiteren Ausführungsform einer erfindungsgemäßen Schaltung,
Fig. 6: ein Ersatzschaltbild eines ersten Filters mit Tiefpasscharakteristik,
Fig. 7: ein Ersatzschaltbild eines weiteren ersten Filters mit Tiefpasscharakteristik, und
Fig. 8: ein Ersatzschaltbild eines analogen Delta-Sigma-Modulators,
Fig. 9: eine schematische Darstellung einer erfindungsgemäßen Schaltung und des Signalgangs bei der Signalübertragung zwischen einem Primär- und einem Sekundärkreis, welche durch eine galvanische Barriere voneinander getrennt sind,
Fig. 10: eine schematische Darstellung eines Sendeteils der Schaltung,
Fig. 11: eine schematische Darstellung eines Empfangsteils der Schaltung,
Fig. 12: ein Ablaufdiagramm eines Verfahrens zur Erzeugung eines im Wesentlichen sinusförmigen Wechselstromsignals mittels einer digitalen Schalteinheit,
Fig. 13: ein Ablaufdiagramm eines Verfahrens zur Erzeugung eines Eingangswerts für einen digitalen Digital-Analog-Konverter,
Fig. 14a): ein erstes Ablaufdiagramm eines Verfahrens zum Betreiben eines digitalen Digital-Analog-Konverters,
Fig. 14b): ein zweites Ablaufdiagramm eines Verfahrens zum Betreiben eines digitalen Digital-Analog-Konverters,
Fig. 15: ein Spektrum eines einzustellenden Wechselstromsignals während verschiedener Stadien des Verfahrens der Erzeugung,
Fig. 16: eine schematische Darstellung eines 3-bit Sinussignal als Folge von unterschiedlichen Zahlenwerten,
Fig. 17: eine schematische Darstellung eines 4-bit Sinussignal als Folge von unterschiedlichen Zahlenwerten,
Fig. 18: eine schematische Darstellung eines CIC-Dezimationsfilters,
Fig. 19: eine schematische Darstellung einer Schaltung zur Trennung des Gleichstrom- und Wechselstromanteils aus dem zweiten Datenstrom,
Fig. 20:eine schematische Darstellung einer Schaltung zur Generierung eines Carrier Detect- und eines RxD-Signals.

Figur 1 zeigt eine schematische Darstellung des ersten Systems S1 und des zweiten Systems S2, die über eine Stromschleife L, hier ein zweiadriges Kabel, miteinander verbunden sind. Das erste System S1 ist bspw. ein Feldgerät der Prozessautomatisierungstechnik. Bei dem Feldgerät kann es sich insbesondere um einen Aktor oder um einen Messaufnehmer/Sensor handeln.

Über die Stromschleife L kann durch einen Wert des Gleichstromsignals des in der Stromschleife L eingestellten Stroms eine Mess- und/oder Regelgröße übertragen werden. Über die Stromschleife L kann auch ein Wechselstromsignal, z.B. mittels des HART-Protokolls übertragen und für die digitale Signalübertragung genutzt werden. Das zweite System S2 kann eine übergeordnete Einheit, insbesondere eine Prozessleitstelle oder eine Prozesssteuerung, sein. Eine Steuereinheit CPU zum Erzeugen eines ersten Datenstroms U1, der das einzustellende Gleichstromsignal und Wechselstromsignal enthält und eine Stromausgangsschaltung S zur Umwandlung des ersten Datenstrom U1 in das Gleichstromsignal und das Wechselstromsignal können in dem ersten System S1 integriert sein.

Exemplarisch zeigt Figur 2 das Frequenzspektrum des in der Stromschleife L nach dem 4-20 mA Standard und dem HART-Protokoll übertragenen analogen Stromsignals. Das Gleichstromsignal und das Wechselstromsignal, überlagern sich in der Stromschleife L und bilden das analoge Stromsignal. Die Signalübertragung erfolgt in zwei verschiedenen Frequenzbändern AB, DB. Um dieses Frequenz-Multiplexing hardwaremäßig zu realisieren, sind somit Bandpass und/oder Tiefpassfilter, insbesondere einer höheren Ordnung, erforderlich, um das Wechselstromsignal von dem Gleichstromsignal zu trennen. Das Gleichstromsignal kann z.B. ein 4-20 mA Signal sein. Ein solches Signal ist besonders niederfrequent (z.B. 0-30 Hz) und unterscheidet sich damit von den für die Digitalübertragung verwendeten Frequenzen f des Wechselstromsignals von oberhalb 100 Hz.

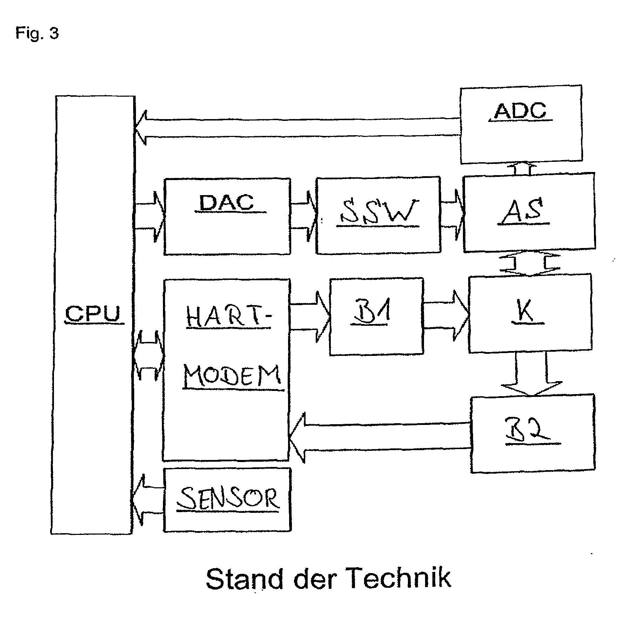

Figur 3 zeigt ein Ersatzschaltbild einer Steuereinheit CPU und einer Stromausgangsschaltung S aus dem Stand der Technik. Die Steuereinheit CPU ist bspw. mit einem Sensor oder einem Aktor verbunden, welcher von der Steuereinheit CPU aus gesteuert und/oder ausgelesen werden kann. Der Sensor erzeugt bspw. eine analoge, der Messgröße entsprechende Spannung. Ist die Steuereinheit CPU bspw. mit einem solchen Sensor verbunden, so wird eine von dem Sensor aufgenommene Messgröße von der Steuereinheit CPU bspw. in einen digitalen Wert umgesetzt, welcher mittels eines Digital-Analog-Wandlers DAC wiederum in eine analoge Signalgroße, das Gleichstromsignal, umgesetzt wird. Diese Signalgröße wird in der Stromschleife L, welche mit dem zweiten System S2 verbunden ist, eingestellt. Vom Anschluss AS der Stromschleife L wird das dort anliegende analoge Stromsignal auf einen Analog-Digital-Wandler ADC aufgeschaltet. Dieser setzt das analoge Signal in ein digitales Signal um, welches von der Steuereinheit CPU gelesen werden kann. Auf diese Art und Weise kann mittels der Steuereinheit CPU überprüft werden, ob der analoge Übermittlungskanal bis zum Anschluss AS an die Stromschleife L ordnungsgemäß funktioniert. Es genügt dazu, den rückgelesenen Istwert des Analogsignals an der Stromschleife L mit dem erwarteten Sollwert zu vergleichen. Im Fehlerfall können geeignete Maßnahmen, z.B. durch Aktivierung einer Alarmleuchte oder eines Alarmsignals, ergriffen werden.

Um zusätzlich zum analogen Signal auch die Vorteile der digitalen Kommunikation mit der übergeordneten Einheit nutzen zu können, enthält das erste System S1 die in Figur 3 skizzierten Schaltungsteile: HART-Modem und analoge Filter, wie bspw. den Bandpass B1 und den Bandpass B2. Die Steuereinheit CPU überträgt die Signalpegel bspw. einer asynchronen seriellen Schnittstelle an eine digitale Schaltung, das sogenannte HART-Modem. Das HART-Modem generiert ein Ausgangssignal, welches mittels eines ersten Bandpasses B1 analog gefiltert wird, um dann auf die Stromschleife L aufgekoppelt zu werden. Für die Kommunikation in Gegenrichtung erfolgt ebenfalls eine analoge Filterung der Signalpegel in der Stromschleife L über einen zweiten Bandpass B2. Das Ergebnis dieser Filterung wird an eine digitale Demodulationsschaltung, die bspw. Teil des HART-Modems sein kann, übergeben und in ein Signal für eine asynchrone digitale Schnittstelle umgesetzt, welche an die Steuereinheit CPU angeschlossen ist. Für diese Filterung sind mehrstufige aktive analoge Filter erforderlich.

Die in Figur 3 aus dem Stand der Technik gezeigte Stromausgangschaltung S besteht also im Wesentlichen aus dem Digital-Analog-Wandler DAC, dem HART-Modem, einem Spannungs-Strom-Wandler SSW, einer Wechselstrom-Kopplungseinheit K, dem Anschluss AS an die Stromschleife L und einem Analog-Digital-Wandler ADC zur Funktionskontrolle. Charakteristisch für die in Figur 3 gezeigte Steuereinheit CPU und Stromausgangsschaltung S ist, dass die einzelnen Schaltungsteile über eine Vielzahl analoger oder digitaler Leitungen miteinander verbunden sind. Ist eine galvanische Trennung zum Anschluss AS an die Stromschleife L, d.h. zwischen Stromausgangsschaltung S und Steuereinheit CPU erforderlich, so müssen entweder analoge Signale über die galvanische Barriere GB übertragen werden oder alternativ eine große Anzahl digitaler Signale. Die Umsetzung einer galvanischen Trennung ist somit mit hohem schaltungstechnischem Aufwand und mit hohen Kosten verbunden.

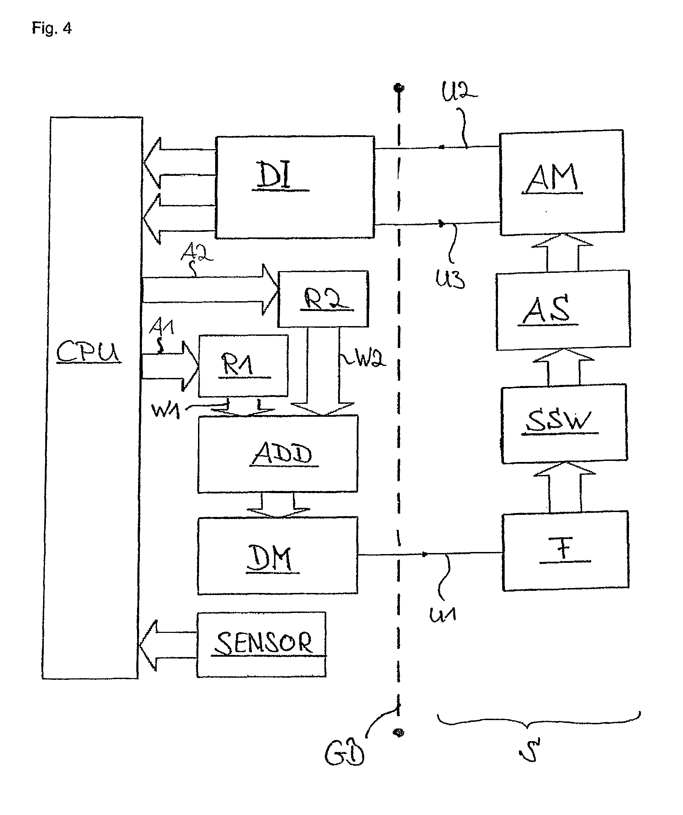

Figur 4 zeigt eine Ausgestaltung der erfindungsgemäßen elektrischen und/oder elektronischen Schaltung, im Folgenden auch Schaltung genannt. Die Schaltung kann über mehrere Teilschaltungen verfügen, die unterschiedliche Funktionalitäten der Schaltung gewährleisten. Die Schaltung ist in zwei Teilbereiche, den Primärkreis und den Sekundärkreis, unterteilt, die galvanisch voneinander getrennt sind. Die galvanische Trennung kann zwischen der Steuereinheit CPU und der Stromausgangschaltung S vorliegen, und ist in Figur 4 durch die gestrichelte Linie angedeutet. Durch die galvanische Trennung wird der Primärkreis, im Wesentlichen bestehend aus Sensor und Steuereinheit CPU, von dem Sekundärkreis, im Wesentlichen bestehend aus Stromausgangschaltung S, Stromschleife L und zweitem System S2, getrennt. Eine Übermittlung des ersten und zweiten Datenstroms U1, U2 kann bspw. über lediglich drei digitale Austauschsignale U1, U2, U3 erfolgen und z.B. mittels drei Übermittlungseinheiten, nicht gezeigt, realisiert werden. Ein wesentlicher Vorteil der Schaltung besteht darin, dass zur Übermittlung des ersten Datenstroms U1 ausschließlich digitale Bauteile in dem Primärkreis verwendet werden. Sämtliche analogen Bauteile befinden sich in dem von dem Primärkreis galvanisch getrennten, elektrisch isolierten, Sekundärkreis. Damit werden Übermittlungen von Störsignalen, welche z.B. durch schnelle Takte der Steuereinheit CPU verursacht werden können, auf die analogen Schaltungsteile unterbunden.

Der erste und der zweite Datenstrom U1, U2 können über zwei Übermittlungseinheiten, nicht gezeigt, übermittelt werden. Der in der Steuereinheit CPU und der Stromausgangsschaltung S vorliegende Takt CLK kann über ein drittes Austauschsignal U3 über eine dritte Übermittlungseinheit, nicht gezeigt, übermittelt werden. Synchron mit dem z.B. von der Steuereinheit CPU generierten Takt CLK wird über die zwei Übermittlungseinheiten je ein Datenstrom U1, U2 übertragen. Auf die Verwendung einer separaten Übermittlungseinheit für den Takt CLK kann verzichtet werden, wenn aus dem Stand der Technik bekannte sogenannte Takt-Regenerationsschaltungen (Clock Recovery) verwendet werden und der Takt CLK aus dem jeweiligen Datenstrom extrahiert wird. Der in Richtung der Stromschleife L übermittelte erste Datenstrom U1 wird z.B. von einem digitalen Delta-Sigma-Modulator DM erzeugt. Der digitale Delta-Sigma-Modulator DM wandelt ein eingangsseitig anliegendes digitales Signal ausgangsseitig in ein ebenfalls digitales Signal, insbesondere einen Bitstrom, um. In einer Ausführungsform kann dafür ein digitaler Delta-Sigma-Modulator DM zweiter Ordnung verwendet werden. In dem vom digitalen Delta-Sigma-Modulator DM erzeugten ersten Datenstrom U1 ist sowohl der niederfrequente Anteil des einzustellenden Gleichstromsignals als auch der höherfrequente Anteil des einzustellenden Wechselstromsignals digital verschlüsselt.

Der erste Datenstrom U1 wird über eine galvanische Barriere GB übertragen und auf ein erstes Filter F mit Tiefpasscharakteristik aufgeschaltet. Vorteilhafterweise wird dieses erste, analoge Filter F ausschließlich durch passive Bauelemente realisiert. Der Verzicht auf aktive Bauelemente z.B. Halbleiterbauelemente ermöglicht es, in einfacher Form eine hohe Linearität des ersten Filters F sicherzustellen. Der Verzicht auf aktive Bauelemente, wie Transistoren oder Operationsverstärker für das erste Filter F reduziert gleichzeitig auch die Herstellungskosten der Schaltung.

Der erste Datenstrom U1 wird mittels einem ersten und einem zweiten Steuersignal S1, S2 erzeugt. Das erste und das zweite Steuersignal A1, A2 werden von der Steuereinheit CPU erzeugt und ausgegeben, wobei das erste Steuersignal A1 zur Erzeugung des Gleichstromsignals und das zweite Steuersignal A2 zur Erzeugung des Wechselstromsignals dient. Das erste Steuersignal A1 wird an ein erstes Register R1 übertragen, welches dem ersten Steuersignal A1 entsprechende, insbesondere digitale, Werte W1 ausgibt. Das zweite Steuersignal A2 wird an ein zweites Register R2 übertragen, welches dem zweiten Steuersignal A2 entsprechende, insbesondere digitale, Werte W2 ausgibt. Mittels eines Addierers ADD werden die Werte W1, W2 zusammengefasst und an den digitalen Delta-Sigma-Modulator DM weitergeleitet. Durch den digitalen Delta-Sigma-Modulator DM wird dann der erste Datenstrom U1 erzeugt.

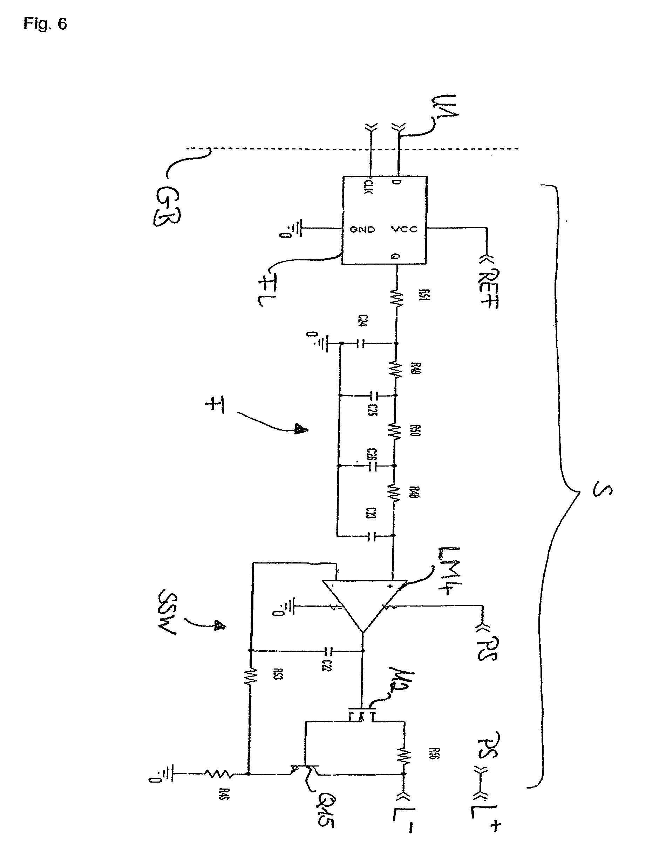

Figur 6 zeigt ein Ersatzschaltbild eines ersten Filters F mit Tiefpasscharakteristik. Der erste Filter F besteht im Wesentlichen aus einer Kaskade aus RC-Gliedern. In Figur 6 ist ein erster Filter F gezeigt, welcher aus einer 4-stufigen Kaskade besteht. Ein erstes RC-Glied besteht dabei aus dem fünfzehnten Widerstand R51 und dem ersten Glättungskondensator C24. Ein zweites RC-Glied besteht dabei aus dem sechzehnten Widerstand R49 und dem zweiten Glättungskondensator C25. Ein drittes RC-Glied besteht dabei aus dem siebzehnten Widerstand R50 und dem ersten dritten Glättungskondensator C26. Ein viertes RC-Glied besteht dabei aus dem achtzehnten Widerstand R48 und dem vierten Glättungskondensator C23. Der erste Filter F gibt als gefiltertes Ausgangssignal ein Spannungssignal aus, welches auf einen Spannungs-Strom-Wandler SSW gegeben und in ein Stromsignal umgesetzt wird. Der Spannungs-Strom-Wandler SSW ist in Fig. 6 mittels eines Operationsverstärker LM4, eines Feldeffekttransistor M2 und eines diskreten Transistors Q15 realisiert. Operationsverstärker LM4 und Transistoren Q15, M2 regeln den Spannungsabfall an einem Shuntwiderstand R46 so aus, dass die am Shuntwiderstand R46 abgegriffene Spannung exakt der Ausgangsspannung des ersten Filters F mit Tiefpasscharakteristik entspricht. Diese am Shuntwiderstand R46 abgegriffene Shuntspannung US ist direkt proportional zu dem in der Stromschleife L eingestellten Stromsignal.

Ist im ersten Datenstrom U1 sowohl die niederfrequente als auch die höherfrequente Signalkomponente, d.h. das einzustellende Gleichstromsignal und das Wechselstromsignal, verschlüsselt, so kann mittels der in Fig. 6 gezeigten Schaltung sowohl das aus dem Gleichstromsignal bestehende "Analogsignal" als auch das aus dem Wechselstromsignal bestehende "HART"-Signal auf die Stromschleife L aufgeschaltet werden. Nach Glättung des ersten Datenstroms U1 im ersten Filter F mit Tiefpasscharakteristik ergibt sich am nicht invertierenden Eingang des Operationsverstärkers LM4 eine Analogspannung mit einer Gleichspannungs- und einer Wechselspannungskomponente. Durch den Feldeffekttransistor M2 und den Transistor Q15 wird dann ein entsprechendes Stromsignal in der Stromschleife L eingestellt. Dafür ist die Stromausgangsschaltung S an die elektrisch negative Seite L- der Stromschleife L angeschlossen. Die elektrisch positive Seite L+ der Stromschleife L ist an der Spannungsversorgung PS angeschlossen. Der Operationsverstärker LM4 der Stromausgangsschaltung S wird von der Spannungsversorgung PS gespeist.

Die Verschlüsselung des einzustellenden Gleichstromsignals und des einzustellenden Wechselstromsignals in dem ersten Datenstrom U1 kann dadurch realisiert werden, dass die Eingangsgröße, aus welcher der digitale Delta-Sigma-Modulator DM den ersten Datenstrom U1 errechnet wird, durch die Summe von zwei unterschiedlichen Komponenten, bspw. dem ersten und dem zweiten Steuersignal A1, A2 oder daraus abgeleiteten Signalen W1, W2, gebildet wird: einer niederfrequenten Komponente für das einzustellende niederfrequente Gleichstromsignal und einer schneller oszillierenden Komponente für das einzustellende Wechselstromsignal. In der schneller oszillierenden Komponente können die digitalen Kommunikationssignale verschlüsselt sein, welche für die digitale Kommunikation mit dem zweiten System S2 genutzt werden.

Der zeitliche Verlauf der Schaltflanken des ersten Datenstroms U1, der bspw. aus einem Bitstrom besteht, wird im Allgemeinen während der Übermittlung über die galvanische Barriere GB verfälscht. In Figur 6 ist die galvanische Barriere GB durch die gestrichelte Linie angedeutet. Es entsteht ein sog. Jitter. Um den Einfluss dieses Jitters zu vermeiden, enthält die Schaltung aus Fig. 6 zunächst ein Flip-Flop FL, hier ein D-Flip-Flop, welches den ersten Datenstrom U1 auf einen Takt CLK aufsynchronisiert, der bspw. in beiden voneinander galvanisch getrennten Bereichen, dem Primär - und dem Sekundärkreis, verfügbar ist. Für die Funktion ist dabei nicht relevant, in welchem der beiden galvanisch voneinander getrennten Bereiche der Takt CLK generiert wird. Entscheidend ist lediglich, dass die Signalverarbeitung in beiden Bereichen mit dem gleichen Takt CLK erfolgt.

Das Flipflop FL aus Fig. 6 wird mit einer präzisen Referenzspannung REF, die an dem Versorgungseingang VCC des Flip-Flops FL anliegt, betrieben. Diese Referenzspannung REF ermöglicht, die am Eingang des Operationsverstärkers LM4 anliegende Spannung präzise festzulegen. Enthält z.B. der erste Datenstrom U1 ein Bitmuster, welches 50% der Zeit High- und 50% der Zeit Low-Pegel führt, so ergibt sich am Ausgang des Flip-Flops FL 50% der Zeit eine Spannung von Null Volt und 50% der Zeit die Referenzspannung REF. Am ersten Filter F, einem passiven RC-Filter, aus Fig. 6 ergibt sich damit im zeitlichen Mittel exakt die Hälfte der Referenzspannung REF. Für den Fall, dass die erste Übermittlungseinheit, welche den ersten Datenstrom U1 über die galvanische Barriere GB überträgt, nur eine geringe Signalverfälschung, auch als Jitter bezeichnet, verursacht, kann auf den Einsatz eines Flip-Flops FL verzichtet werden. In diesem Fall kann der erste Datenstrom U1 von der ersten Übermittlungseinheit direkt mit dem Eingang des ersten Filters F mit Tiefpasscharakteristik verbunden werden.

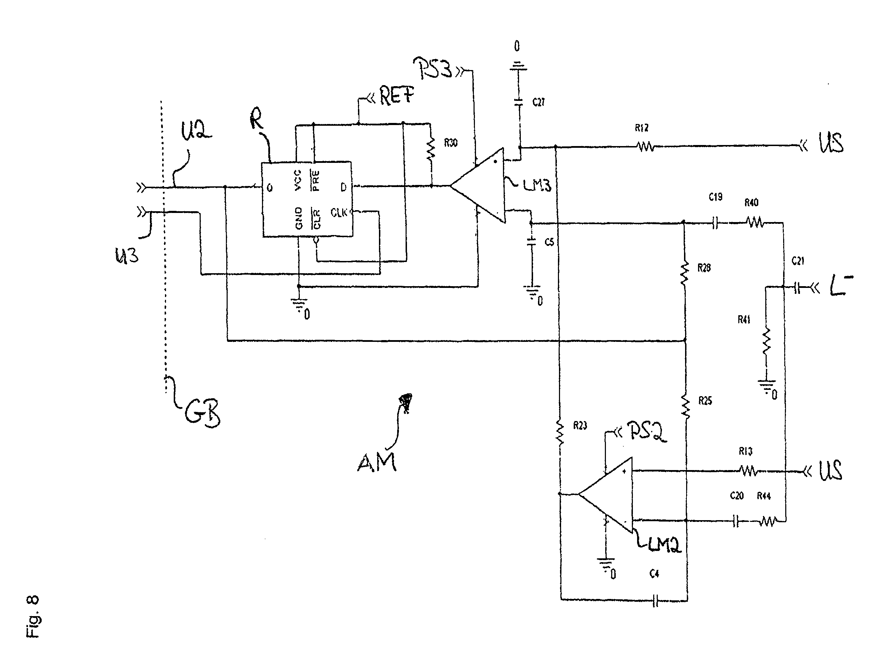

Um eine bidirektionale Signalübertragung und somit auch Kommunikation des ersten Systems S1 mit dem zweiten System S2 zu ermöglichen, ist es erforderlich, dass die Steuereinheit CPU aus Fig. 4 Informationen über das in der Stromschleife L eingestellte Stromsignal erhält, in denen das zweite System S2, bspw. eine übergeordnete Einheit, ihre digital zu übertragende Information verschlüsselt. Gleichzeitig ist für die Überwachung der Funktion der Stromausgangsschaltung S aus Fig. 4, die mehrheitlich aus analogen Bauteilen besteht, erforderlich, eine Information über das in der Stromschleife L eingestellte Stromsignal an die Steuereinheit CPU weiterzuleiten. Dieses Stromsignal ist proportional zur Shuntspannung US, welche bspw. an dem in Figur 6 gezeigten Shuntwiderstand R46 abgegriffen werden kann. Die Übertragung der Informationen an die Steuereinheit CPU kann beispielsweise durch einen analogen Delta-Sigma-Modulator AM realisiert werden, wie er bspw. in Fig. 8 gezeigt ist.

Der von dem analogen Delta-Sigma-Modulator AM ausgegebene Datenstrom, bspw. ebenfalls ein Bitstrom, kann als zweiter Datenstrom U2 verwendet werden, welcher über die galvanische Barriere GB in Richtung Steuereinheit CPU übertragen wird. Dieser zweite Datenstrom U2 wird synchron zu einem Takt CLK generiert, der z.B. von der Steuereinheit CPU erzeugt wird und an den analogen Delta-Sigma-Modulator AM in Figur 8 übertragen werden kann. Die gestrichelte Linie in Figur 8 symbolisiert die galvanische Barriere GB.

In dem zweiten Datenstrom U2 werden zwei Signalkomponenten verschlüsselt, welche dem analogen Delta-Sigma-Modulator AM eingangsseitig zugeführt werden. Einerseits handelt es sich um eine Shuntspannung US, welche proportional zum Strom ist, welcher in der Stromschleife L fließt. Andererseits handelt es sich um ein Spannungssignal, welches dem Wechselstromsignal in der Stromschleife L entspricht. Das Spannungssignal wird zu diesem Zweck auf ein passives analoges Hochpassfilter gegeben und wechselstromentkoppelt auf den Delta-Sigma-Modulator aufgeschaltet. Das wird mittels eines zwischengeschalteten elften Kondensators C21 erreicht, der dazu dient Gleichspannungsanteile herauszufiltern. In einer vorteilhaften Ausführung wird dieses Hochpassfilter um eine Schaltungsstufe mit einer Frequenzcharakteristik ergänzt, welche zum Beispiel Netzfrequenzen von 50 oder 60 Hz unterdrückt und somit Störpegel verringert.

Ein solcher analoger Delta-Sigma-Modulator AM kann, im Gegensatz zu den aus dem Stand der Technik bekannten analogen Delta-Sigma-Modulatoren AM, mit geringeren Bauteilekosten aufgebaut werden, da keine Integrierten Schaltkreise verwendet werden. Im Unterschied zu den aus dem Stand der Technik bekannten Schaltungen ermöglicht der vorgeschlagenen analoge Delta-Sigma-Modulator AM zusätzlich zum Empfang digitaler Daten von der übergeordneten Einheit auch das Rücklesen des innerhalb der Stromschleife L fließenden Stroms und damit die Überwachung des ersten Filters F.

Die Komponenten eines analogen Delta-Sigma-Modulators AM werden aus den folgenden drei Schaltungselementen gebildet: erstens aus einem digitalen Register R (in Fig. 8 durch das Flip-Flop FL realisiert), welches das Ausgangssignal eines Komparators LM3 auf einen Takt CLK aufsynchronisiert. Drittens verknüpft ein sogenanntes Schleifenfilter sowohl die analogen Eingangssignale des analogen Delta-Sigma-Modulators AM als auch das Ausgangssignal des Registers R mit dem Eingang des Komparators LM3. Im Zusammenhang mit Fig. 8 bezeichnet "Schleifenfilter" diejenigen Bauelemente, welche in einem analogen Regelkreis den Ausgang des Registers R (Signal Modulator Out) in Form einer sogenannten "Regelschleife" mit dem Eingang des Komparators LM3 verknüpfen.

Die Frequenzcharakteristik dieses Schleifenfilters legt die Frequenzcharakteristik des Digitalisierungsrauschens und damit die Auflösung des analogen Delta-Sigma-Modulators AM fest. Je höher die Ordnung dieses Tiefpasses, desto effektiver kann das Quantisierungsrauschen unterdrückt werden. Jedoch ist bezüglich des Aussteuerverhaltens und bezüglich der Stabilität des Regelkreises des analogen Delta-Sigma-Modulators AM eine zu hohe Filterordnung unvorteilhaft. Das Schleifenfilter aus Fig. 8 weist damit eine Filtercharakteristik zweiter Ordnung auf, wobei die erste Ordnung des Filters bzw. der erste Pol der zugehörigen Übertragungsfunktion durch die Integratorschaltung (zehnter Widerstand R25, achter Kondensator C4, Operationsverstärker LM2) gebildet wird und die zweite Ordnung, bzw. der zweite Pol der Übertragungsfunktion durch das aus dem siebten Widerstand R23 und dem sechsten Kondensator C27 bestehende RC-Filter gebildet wird.

Das Schleifenfilter des analogen Delta-Sigma-Modulators AM in Fig. 8 wird durch ein sogenanntes zeitkontinuierliches Filter realisiert. Dies ermöglicht mit besonders preisgünstigen Operationsverstärkern LM2, LM3 mit geringer Bandbreite und geringer Leistungsaufnahme arbeiten zu können. Aus dem Stand der Technik bekannte analoge Delta-Sigma-Modulatoren AM arbeiten üblicherweise mit sogenannten zeitdiskreten Schleifenfiltern (Switched-Capacitor-Filter), welche jedoch ohne die Entwicklung eines spezialisierten Integrierten Schaltkreises nur schwer und damit teuer realisiert werden können. Eine weitere Besonderheit ist, dass das in Figur 8 gezeigte Schleifenfilter eine Filtercharakteristik zweiter Ordnung realisiert, dafür jedoch lediglich einen Operationsverstärker LM2 benötigt.

Eine weitere Besonderheit besteht darin, dass der analoge Delta-Sigma-Modulator AM aus Fig. 8 über zwei separate Eingangspfade verfügt, welche unabhängig voneinander eine Gleichspannungs - und eine Wechselspannungskomponente auf das Schleifenfilter aufkoppeln. Bezüglich der Dimensionierung des Arbeitstaktes des analogen Delta-Sigma-Modulators AM sind die folgenden Betrachtungen bedeutsam. Um mit preisgünstigen Schaltungskomponenten auszukommen, z.B. mit Operationsverstärkern mit einem geringen Verstärkungs-Bandbreiteprodukt (Gain Bandwidth Product) von z.B. 1 MHz, ist es vorteilhaft, sich beim (Daten-)Takt CLK auf Frequenzen unterhalb von ca. 3 MHz zu beschränken. Andererseits ist eine ausreichende sogenannte Oversampling-Rate erforderlich, um sicherzustellen, dass die größte gewünschte Nutzfrequenz des analogen Delta-Sigma-Modulators AM mit ausreichend geringer Verfälschung übertragen wird. Arbeitet man zweckmäßig z.B. mit einer Oversampling-Rate von mindestens 64 und einer Nutzfrequenz von max. 5 kHz, so ergibt sich für den Takt CLK ein sinnvoller Minimalwert von rund 300 kHz. Vorteilhafterweise wird somit für den Takt CLK eine Frequenz zwischen 200kHz und 4 MHz verwendet. Soll der Modulator nur fürs Zurücklesen des Gleichstromsignals verwendet werden, kommen auch geringere Taktfrequenzen in Betracht, z.B. von 64 * 30 Hz = 2 kHz.

Sowohl das Gleichstromsignal als auch das Wechselstromsignal finden sich digital verschlusseit in dem am Ausgang des Registers R abgreifbaren zweiten Datenstrom U2 wieder, welcher über die galvanische Barriere GB hinweg an die Steuereinheit CPU und/oder Auswerteeinheit weitergeleitet werden kann. In einem digitalen Dezimationsfilter DI können der dem Gleichstromsignal entsprechende Anteil und der dem Wechselstromsignal entsprechende Anteil des zweiten Datenstroms U2 wiederum voneinander getrennt und an die Steuereinheit CPU weitergeleitet werden. Mittels digitaler Signalverarbeitung können dann aus dem dem Wechselstromsignal entsprechenden Anteil des zweiten Datenstroms U2 die digitalen Daten extrahiert werden, welche bspw. die übergeordnete Einheit in die Stromschleife L einstellt hat. Eine Auswertung ermöglicht damit den Empfang von digitalen Daten seitens der Steuereinheit CPU. Von Vorteil ist, dass die Verschlüsselung von Gleichstromsignalen und Wechselstromsignalen auf einer einzelnen Digitalleitung mittels Delta-Sigma-Modulatoren möglich ist und die Erzeugung der Datenströme U1, U2 ohne großen Hardware-Aufwand gelingt. Ein digitaler Delta-Sigma-Modulator DM kann z.B. mit nur wenig Logikressourcen innerhalb in eines sogenannten Field Programmable Gate Arrays FPGA oder eines sogenannten Complex Programmable Logic Device CPLD Integrierten Schaltkreises realisiert werden. Auch ein analoger Delta-Sigma-Modulator AM lässt sich mit einer geringen Anzahl elektronischer Bauelemente einfach aufbauen. Es werden im Minimalfall nur ein Operationsverstärker LM2 und ein Komparator LM3 benötigt. Die Anzahl der elektronischen Komponenten ist damit weit geringer als bei im Stand der Technik verwendeten konventionellen Lösungen. Dies geht mit einer erhöhten Robustheit und geringeren Bauteilekosten einher. Ein weiterer Vorteil der erfindungsgemäßen Schaltung besteht darin, dass die Anzahl der Schaltungskomponenten, welche für die Erzeugung und Überwachung der analogen 4-20 mA Signale benötigt werden, sehr gering ist.

Insbesondere kann die eigentlich als Stromausgang S konzipierte Schaltung mit der erfindungsgemäßen Rückleseschaltung ohne Mehrkosten auch als "Stromeingang" genutzt werden. Dafür kann ein Betriebsmodus des ersten der Steuereinheit CPU und der Stromausgangsschaltung S vorgesehen sein. Bei der Nutzung der in Figur 4 gezeigten Schaltung als "Stromeingang" wird das erste System S1 über eine Stromschleife L mit einem zweiten System S2 verbunden, welches zweite System S2 den innerhalb der Stromschleife L fließenden Strom bspw. mittels einer Stromquelle oder einer anderen vorgesehenen Einheit auf einen Stellwert begrenzen kann. Wird der Strom des Spannungs-Strom-Wandlers SSW aus Fig. 4 auf einen maximalen Wert eingestellt, so wird der innerhalb der Stromschleife L fließende Strom nicht durch die Steuereinheit CPU und die Stromausgangschaltung S begrenzt, sondern vielmehr durch die Stromquelle oder die dafür vorgesehene Einheit des zweiten Systems S2 auf den Stellwert begrenzt. Der Rücklesekanal aus Fig. 8 liefert in diesem Fall den effektiv innerhalb der Stromschleife L fließenden Strom zurück. Die kombinierte Schaltung bestehend aus Steuereinheit CPU und Stromausgangschaltung S arbeitet in diesem Fall als "Stromeingang". Für die Genauigkeit des im Betrieb als Stromausgang S generierten Gleichstromsignals bestimmend sind, neben der Genauigkeit der Referenzspannung REF mit der das Flip-Flop FL betrieben wird, die Genauigkeit des Shuntwiderstands R46 und die Genauigkeit des ersten Filters F.

Da im Fall von Nebenschlusswiderständen eine Genauigkeit von wenigen ppm auch für Präzisionswiderstände unter Serienbedingungen nicht gewährleistet werden kann, ist in der Praxis ein Abgleich der Schaltung zur Generierung der Gleichstromsignale und Wechselstromsignale erforderlich. Für die in der Fertigung erforderlichen Prozesszeiten ist für die Abgleichdauer die Einschwingzeit der Schaltung maßgeblich. Diese Einschwingzeit wird in dem Ausführungsbeispiel in Fig. 6 in erster Linie durch die Frequenzcharakteristik des analogen, ersten Filters F, bestehend aus der RC-Filter-Kaskade, vorgegeben. Ein wesentlicher Vorteil der erfindungsgemäßen Schaltung besteht darin, dass bei Verwendung eines digitalen Delta-Sigma-Modulators DM zur Generierung des ersten Datenstroms U1 ein erster Filter F mit einer besonders hohen Grenzfrequenz verwendet werden kann. Vorteilhafterweise wird diese Grenzfrequenz in der Größenordnung der maximalen Frequenz der Wechselstromkomponente gewählt, welche für die digitale Datenkodierung genutzt wird. Im Fall des HART-Protokolls beispielsweise oberhalb von ca. 2.2 kHz (Baudrate 1200 BPS) oder ca. 6 kHz (Baudrate 4.8 BPS). Durch Verwendung dieser hohen Grenzfrequenz ergibt sich automatisch eine besonders geringe Einschwingzeit. Diese kurze Einschwingzeit ermöglicht z.B. den Abgleich einer Elektronikbaugruppe innerhalb einer besonders kurzen Prüfzeit.

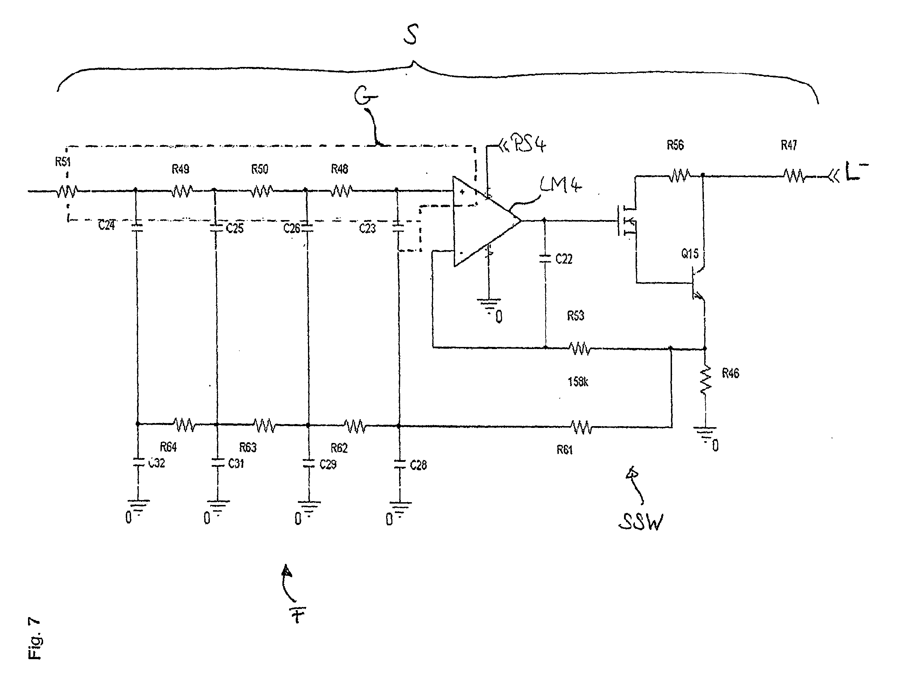

In einer Ausführungsform verfügt die erfindungsgemäße Schaltung über einen nichtflüchtigen Speicher, beispielsweise in Form eines sogenannten EEPROMs oder FLASH-Speichers. Nach Durchführung der Abgleichmessung können Korrekturwerte ermittelt und im Speicher abgelegt werden, welche die rechnerische Kompensation der Toleranzen des Shuntwiderstands R46 ermöglichen und somit eine hohe Genauigkeit des Stromsignals in der Stromschleife L. Auf die gleiche Weise können auch Toleranzen der verwendeten Referenzspannung REF und eine sich ggf. ausbildende sogenannte Offsetspannung des Operationsverstärkers LM4 aus Figur 6 und Figur 7 ermittelt und kompensiert werden.

Da für die Genauigkeit des innerhalb der Stromschleife L fließenden Stromsignals die am nichtinvertierenden Eingang des Operationsverstärkers LM4 aus Figur 6 anliegende Spannung maßgeblich ist, ist es erforderlich, ggf. fließende Leckströme zu berücksichtigen. Fließt beispielsweise über den zweiten Glättungskondensator C25 aus Fig. 6 ein parasitärer Gleichstrom, z.B. wegen Feuchtigkeitsfilmen auf dem Bauelement, so führt dieser Gleichstrom zu einem Spannungsabfall am zweiten RC-Glied. Analoge Überlegungen gelten für alle Bauelemente des in Fig. 6 gezeigten ersten Filters F mit Tiefpasscharakteristik. Zu einer ebensolchen Verfälschung des Gleichspannungspotentials führt ein Leckstromabfluss, welcher zwischen einem der Widerstandsanschlüsse des ersten Filters F und einem sich in der Nähe befindlichen Bauelement oder einer sich in der Nähe befindlichen Leiterbahn ausbildet. Entscheidend für die Auswirkung eines Leckstromabflusses auf die Genauigkeit des Aufbaus ist die Gleichstromimpedanz des Schaltungsknotens. Nur bei einer hohen Impedanz ergibt sich durch Leckströme ein beaeutsamer Spannungsabfall.

In Fig. 6 betrifft das somit insbesondere die Schaltungsknoten des ersten Filters F, die nicht beliebig niederohmig ausgeführt werden können, weil sonst die Ausgangsimpedanz des Treibergatters - in Fig. 7 das D-Flip-Flop - nicht gering genug ist. In einer vorteilhaften Ausführungsform ist daher der erste Filter F mit einem isolierenden Schutzlack überdeckt. Das Aufbringen einer Schutzlackierung bedeutet für die Erzeugnisfertigung einen zusätzlichen Prozessschritt, welcher Material- und Arbeitskosten verursacht.

In einer vorteilhaften Ausführungsform der Erfindung wir die Ausbildung parasitärer Leckströme der oben beschriebenen Art auf andere Weise unterbunden. Zu diesem Zweck werden der erste, zweite, dritte und vierte Glättungskondensator C24, C25, C26, C23 nicht mehr leitend mit einem Massepotential verbunden, sondern mit einem Schirmsignal, welches näherungsweise das gleiche Gleichspannungspotential aufweist, wie es am nicht invertierenden Eingang des Operationsverstärkers LM4 anliegt, bezüglich höherer Frequenzen jedoch niederimpendant mit dem Massepotential verbunden ist. Vorteilhafterweise wird der Signalpfad des ersten, zweiten, dritten und vierten RC-Gliedes des ersten Filters F außerdem mittels einer Leiterschleife aktiv geschirmt, d.h. mit einem sogenannten Wächter-Ring G (Guard-Ring) umschlossen, wobei dieser Wächterring G ebenfalls mit einem solchen Schirmsignal verbunden ist. Dieser Wächterring G ist auf der Leiterplatte der erfindungsgemäßen Baugruppe vorteilhafterweise nicht mit Isolationsschutzlack überdeckt, d.h. frei von Isolationsschutzlack. Durch Verwendung des Wächterrings G und des Schirmpotentials an dem ersten, zweiten, dritten und vierten Glättungskondensator wird sichergestellt, dass in der Umgebung der hochohmigen Schaltungsknoten des ersten Filters F die Ausbildung einer Gleichstromkomponente unterbunden wird, welche zwischen diesem Knoten und einem anderen Potential fließen könnte. Eine mögliche Realisierung eines Schirmpotentials ist in Figur 7 dargestellt. Das Schirmpotential wird in diesem Fall dadurch generiert, dass eine Spannung genutzt wird, welche das gleiche Wechselspannungspotential führt, wie der nicht invertierende Eingang des Operationsverstärkers LM4. Im Unterschied zum Eingang des Operationsverstärkers LM4 ist diese verwendete Spannung aber wesentlich niederimpedanter.

Das erste Filter F aus Figur 7 kann eine Grenzfrequenz aufweisen, welche die Transmission der für die digitale Kommunikation mit dem zweiten System S2 verwendeten Wechselstromsignal-Frequenzbereiche gestattet. Andererseits soll die Grenzfrequenz ausreichend niedrig sein, um im ersten Datenstrom U1 gegebenenfalls enthaltenes hochfrequentes Signalrauschen ausreichend zu unterdrücken. Ist der erste Datenstrom U1 bspw. ein Bitstrom und wird als Bitrate des Bitstroms beispielsweise eine Frequenz F von 500 kHz bis 1 MHz verwendet, so sollte die Grenzfrequenz des ersten Filters F mit Tiefpasscharakteristik um eine ausreichende sogenannte "Oversampling-Rate" von z.B. 128 bis 256 niedriger liegen als die Datenrate des Bitstroms.

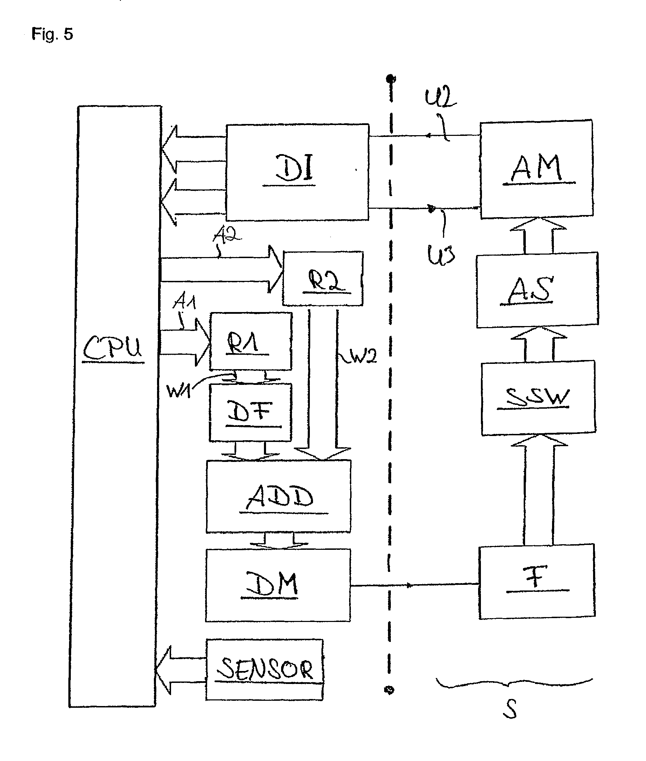

Im Allgemeinen ist jedoch eine sogenannte "flache" Übertragungscharakteristik mittels passiver RC-Glieder nur schwer zu realisieren, d.h. eine Übertragungscharakteristik, welche im relevanten Frequenzband Signale unabhängig von der Frequenz mit gleicher Amplitude überträgt. Im Fall eines Filters mit Tiefpasscharakteristik werden im Allgemeinen höhere Signalfrequenzen stärker bedämpft als niedrigere Signalfrequenzen. Dies kann dazu führen, dass die an das zweite System S2 zu übertragenden Stromsignale höherer Frequenz, z.B. 2200 Hz, stärker bedämpft werden als die Signalkomponenten geringerer Frequenz, z.B. 1200 Hz. Dieses Problem kann dadurch behoben werden, dass an Stelle eines passiven RC-Gliedes ein aktives Filter zum Einsatz kommt. Dies würde jedoch in höheren Kosten und in einer potentiellen Nichtlinearität resultieren. Alternativ ist es möglich die Verzerrung auf andere Weise zu beheben. Zu diesem Zweck kann ein digitales Filter DF hinzugefügt werden, welches die Verzerrung im ersten Filter F mit Tiefpasscharakteristik annähernd kompensiert. Das digitale Filter DF kann an verschiedenen Stellen im Signalpfad positioniert werden. Eine mögliche Position ist in Figur 5 gezeigt.

In einer vorteilhaften Ausführungsform wird die Berechnung der Summe der Steuersignale bzw. des ersten und des zweiten Steuersignals ebenso wie die Steuersignale selbst bzw. das erste und zweite Steuersignal in einem digitalen Schaltkreis durchgeführt. Beispielsweise innerhalb eines sogenannten Gate-Arrays, Structured ASIC oder innerhalb eines sogenannten FPGAs oder CPLDs.

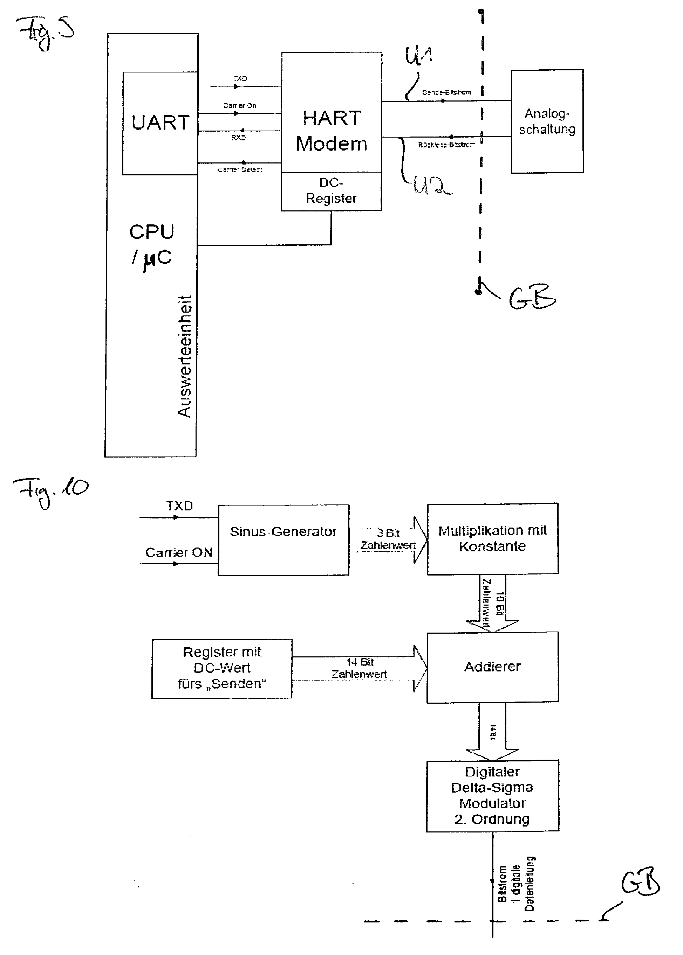

Figur 9 zeigt eine schematische Darstellung einer Ausgestaltung der vorgeschlagenen Schaltung und den Signalgang bei der Signalübertragung zwischen dem ersten und dem zweiten System bzw. dem Primär- und dem Sekundärkreis. Bei der dargestellten Steuereinheit CPU kann es sich um eine Rechnereinheit oder einen Mikroprozessor handeln. Die Steuereinheit kann Teil einer Auswerteschaltung sein, die bspw. zur Generierung von Messwerten, Messsignalen oder deren Verarbeitung dient. Zur Aufnahme der Messsignale kann ein Messaufnehmer/Sensor, nicht gezeigt, dienen. Die Steuereinheit weist eine UART-Schnittstelle zur digitalen Kommunikation mit einem als Sendeteil bezeichneten Teil der Schaltung auf. Der Sendeteil besteht dabei aus einer digitalen Schalteinheit, die zur Erzeugung des einzustellenden Wechselstromsignals respektive HART Signals dient, und einem Register, dass zur Erzeugung des einzustellenden Gleichstromsignals dient. Weiterhin kann ein Addierer und ein digitaler Delta-Sigma-Modulator Teil des Sendeteils sein. Zur Übertragung eines ersten Steuersignals zwischen der Steuereinheit und dem Sendeteil werden über die Datenleitungen TxD, RxD, Carrier On CO und Carrier Detect CD der UART Schnittstelle verwendet, über welche Datenleitungen die entsprechenden Signale übertragen werden. In Figur 9 wird über die Signale TxD, RxD, Carrier On CO und Carrier Detect CD das dem einzustellende HART-Signal entsprechende Wechselstromsignal in dem ersten Datenstrom erzeugt. Mittels des ebenfalls dem Sendeteil zugehörige DC-Registers wird der dem Gleichstromsignal entsprechende Anteil in dem ersten Datenstrom erzeugt. Dafür kann die Steuereinheit über eine Signalleitung mit dem DC-Register verbunden sein. Analogschaltung und Digitalteil können dabei wie in Fig. 9 geziegt über eine galvanische Barriere GB getrennt sein. Über diese Barriere GB wird hier nur der erste Datenstrom D1 und der zweite Datenstrom D2 übertragen.

Figur 10 zeigt eine schematische Darstellung des Sendeteils der Schaltung. Die TxD Signalleitung und das Carrier On Signal werden einer digitalen Schalteinheit zugeführt. Die digitale Schalteinheit wird auch als Sinus-Generator bezeichnet, da diese aus dem ersten TxD und dem Carrier On Signal Zahlenwerte erzeugt, die eine Sinus-Schwingung approximieren. Der Sinus-Generator erzeugt also einen n-Bit-Zahlenwert, aus dem ersten Steuersignal, welches erste Steuersignal hier aus dem TxD und dem Carrier On besteht. Dieser Zahlenwert wird mit einer Konstante multipliziert und einem Addierer zugeführt, der den dem einzustellenden Wechselstromsignal entsprechenden 3-bit Zahlenwert mit dem 14 bit Zahlenwert aus dem Register für den Gleichstromanteil addiert. Dabei wird der 3-bit Zahlenwert skaliert. Das resultierende 14 bit Signal wird einem digitalen Delta-Sigma-Modulator zugeführt, der daraus den ersten Datenstrom, hier einen 1 Bitstrom, erzeugt. Der digitale Delta-Sigma-Modulator kann dabei in 1. oder 2. Ordnung betrieben werden. Der Sinusgenerator zeichnet sich dadurch aus, dass er eine geringe Oberwellenamplitude bei geringem Hardwareaufwand, wie bspw. Logik-Gattern, erzeugt.

Die in Figur 10 gezeigten zwei Schaltungsblöcke bestehen also aus einem Sinus-Generator und einer Multiplikations bzw. Skalierungseinheit, welche auf der Basis eines TXD und eines Carrier On Signals einen zeitveränderlichen 10 Bit Zahlenwert generiert. Der HART-Kommunikationsstandard fordert, dass je nach Signalpegel der TXD Leitung das auf der Stromschleife aufgeprägte Wechselspannungssignal entweder einem 1200Hz (TXD logisch 1) Sinus oder einem 2200Hz Sinus (TXD logisch 0) entsprechen muss. Der HART-Standard legt dabei strenge Anforderungen an die Güte des Sinussignals fest. Weiterhin legt der HART-Standard Grenzwerte für die Amplitude des AC-Signals, d.h. Wechselstromsignals, und eine Nominalamplitude von +/- 0.5 mA fest. In der gezeigten Ausführung liegt der zu sendende Stromwert als Eingangswert mit einer DC und AC-Komponente, das heißt mit einer Wechselstrom- und einer Gleichstromkomponente des einzustellenden Wechselstrom- bzw. Gleichstromsignals, am Eingang eines digitalen Sigma-Delta-Wandlers an, welcher den zeitlich veränderlichen Eingangswert in einen Bitstrom umsetzt. Es besteht dabei ein linearer Zusammenhang zwischen dem am Eingang des Sigma-Delta-Modulators befindlichen Eingangswerts, der bspw. als digitaler Zahlenwert vorliegt, und dem in der Stromschleife eingestellten Stromwert. Die Multikplikationseinheit sorgt dabei dafür, dass der Ausgangswert des Sinusgenerators so skaliert wird, dass die Amplitude einen Stromwert von +/- 0.5 mA kodiert. Prinzipiell kann ein digitaler Sinuswert auf verschiedene Arten generiert werden, beispielsweise durch Tabellierung einer großen Anzahl von Werten, welche einen Sinus mit hoher Genauigkeit approximieren. Eine solche Tabellierung bedeutet für die Realisierung in digitaler Logik im einen umso höheren Schaltungsaufwand, um so höher die Anforderungen an die Genauigkeit der Sinuskurve sind. Der Delta-Sigma-Modulator kann dadurch dass er je nach Bedarf in 1. oder 2. Ordnung betrieben wird, den Aussteuerbereich vom Minimum bis zum Maximum des Zahlenwertebereichs abdecken.

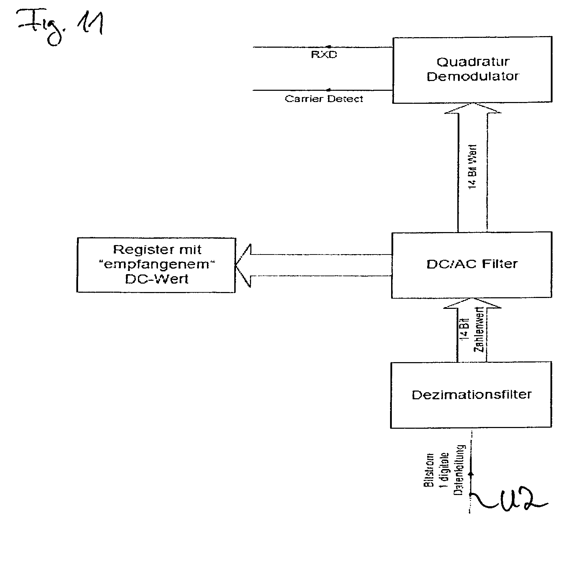

Figur 11 zeigt eine schematische Darstellung des Empfangsteils der vorgeschlagenen Schaltung. Das Empfangsteil kann Teil des ersten Systems sein und dem Primärkreis angehören, d.h. es ist ebenso wie das Sendeteil galvanisch von der Stromausgangsschaltung getrennt. Der zweite Datenstrom U2, hier ein Bitstrom, der aus dem in der Stromschleife L eingestellten Stromsignal abgeleitet wird, durchläuft einen Dezimationsfilter, der einen ersten Zahlenwert, hier mit einer Bitbreite von 14 Bits, ausgibt. Dieser Zahlenwert wird einem Filter zugeführt, der den Gleichstromanteil von dem Wechselstromanteil, der in dem ersten Zahlenwert enthalten ist, trennt. Der Gleichstromanteil wird bspw. als zweiter Zahlenwert mit einer zweiten Bitbreite an ein Register übertragen. Ein aus dem ersten Zahlenwert abgeleiteter dritter Zahlenwert, der den Wechselstromanteil des in der Stromschleife eingestellten Stromsignals beinhaltet, und eine dritte Bitbreite aufweist wird an einen sog. Quadratur Demodulator weitergeleitet der das RxD und das Carrier Detect Signal für die Steuereinheit erzeugt. Die dritte Bitbreite des dritten Zahlenwerts beträgt im gezeigten Ausführungsbeispiel 14 bit. Mittels des Quadratur Demodulators wird der Steuereinheit eine RxD und ein Carrier Detect Signal zur Verfügung gestellt.

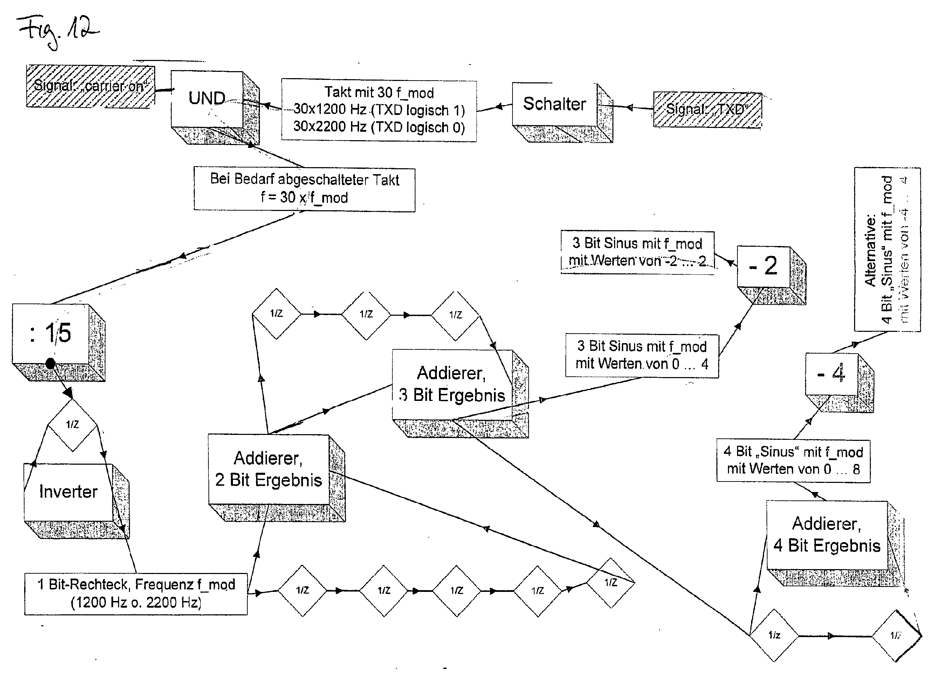

Figur 12 zeigt ein Ablaufdiagramm einer Schaltung, welche es ermöglicht, den Schaltungsaufwand für die Generierung einer Sinuskurve, d.h. eines Sinussignals, drastisch zu reduzieren, und trotzdem die hohen Anforderungen der HART-Spezifikation an die Güte der Sinuskurve zu erfüllen. Die Grundidee besteht darin, ein Schaltnetz zu definieren, welches bewusst keinen idealen Sinus generiert, sondern vielmehr in Kauf nimmt, dass der zeitliche Verlauf der Zahlenwerte Oberwellen der 7. Ordnung und höherer Ordnungen der zu generierenden Sinusschwingung enthält, die Oberwellen bis einschließlich zur 5. Ordnung jedoch im Wesentlichen exakt verschwinden. Dadurch, dass die höheren Oberwellen bewusst in Kauf genommen werden, kann ein Schaltnetz generiert werden, welches mit einem Bruchteil der digitalen Logik auskommt als eine alternative Implementierung auf der Basis einer Tabellierung. Insbesondere kann damit ein Verfahren generiert werden, welches mit einer Bitbreite von nur 3 Bits eine der HART-Spezifikation entsprechende Genauigkeit der Sinuskurve für das Wechselstromsignal erreicht. Es wird dabei ausgenutzt, dass im analogen Schaltungsteil, welcher den Bitstrom des Sigma-Delta-Wandlers weiterverarbeitet, eine Tiefpassfilterung sehr hoher Ordnung durchgeführt wird. Diese Tiefpassfilterung führt dazu, dass ggf. noch vorhandene 6. oder 7. Oberwellen entfernt werden. Für die Güte des auf der digitalen Seite generierten Sinussignals hat dadurch die Amplitude der höheren Oberwellen keinen Einfluss auf die Signalform des an der Stromschleife anliegenden Signals.

Figur 12 zeigt also ein Ablaufdiagramm eines Verfahrens zur Erzeugung eines im Wesentlichen sinusförmigen und bzgl. wenigstens eines Teils der Oberschwingungen gefilterten Wechselstromsignals. Das Verfahren kann bspw. mittels der bereits erwähnten digitalen Schalteinheit durchgeführt werden. Die Steuereinheit erzeugt die Signale Carrier On und TxD und gibt diese aus. Das TxD Signal kann bspw. mit dem 30 fachen der beabsichtigten Modulationsfrequenz, d.h. 1200 oder 2200 Hz, des HART-Signals multipliziert werden. Dies kann in Abhängigkeit eines logischen Werts des TxD Signals geschehen. Dadurch werden High- bzw. Low Bits mit einer Frequenz von 30*1,2 Hz bzw. 30*2,2 kHz erzeugt. Insbesondere kann dadurch eine Sequenz von High- bzw. Low-Bits mit einer Frequenz von f= 30*1,2 kHz bzw. 30*2,2 kHz erzeugt werden. Durch Division und Zeitverzögerung dieser High- bzw. Low-Bits kann eine 1-Bit Rechteckfunktion mit eine Modulationsfrequenz von 1200 oder 2200 Hz erzeugt werden. Das 1-Bit Rechtecksignal wird bspw. mittels Register mit dem Takt f zeitverzögert (entsprechend der 1/Z-Stufe in Abb. 12) und mit dem ursprünglichen 1-Bit Rechtecksignal einem Addierer zugeführt, der aus den zwei 1 Bit Eingangssignalen ein 2-Bit Ausgangssignal erzeugt. Das so erzeugte 2-Bit Signal wird ebenfalls verzögert und mit dem unverzögerten 2 bit Signal wiederum einem Addierer zugeführt, der ein 3 Bit Ausgangssignal ausgibt. Dieses 3 Bit Ausgangssignal kann dann vier Werte annehmen.

Alternativ kann durch das dargestellte Verfahren, bspw. durch eine weitere Verzögerungsschleife und einen Addierer, auch ein 4 Bit Zahlenwert erzeugt werden. Allgemein lassen sich aber Zahlenwerte eines beliebigen Fomats, d.h. mit einer Bitbreite von n Bits erzeugten, wobei n eine natürliche Zahl ist. Die Zeitverzögerung und Addition realisiert dabei eine digitale Filterung des eingangsseitig anliegenden Rechtecksignals.

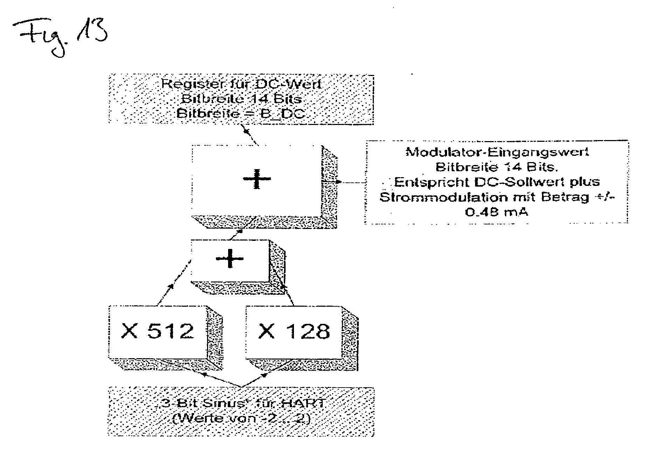

Figur 13 zeigt ein Ablaufdiagramm eines Verfahrens zur Erzeugung eines Eingangswerts für den digitalen Digital-Analog-Konverter. Dafür wird ein Eingangswert bestehend aus 14 Bits erzeugt. Dieser Eingangswert wird aus dem 3-Bit Sinus und einem Wert aus dem Register für die Gleichstromwerte zusammengesetzt. Durch multiplizieren des 3-Bit Sinus und addieren, wird 3 Bit Sinussignal skaliert bzw. geschoben. Der sich daraus ergebenden Eingangswert entspricht dem einzustellenden Gleichstromsignal in der Stromschleife plus der Strommodulation von +- 0,48 mA, d.h. dem einzustellenden Wechselstromsignal.

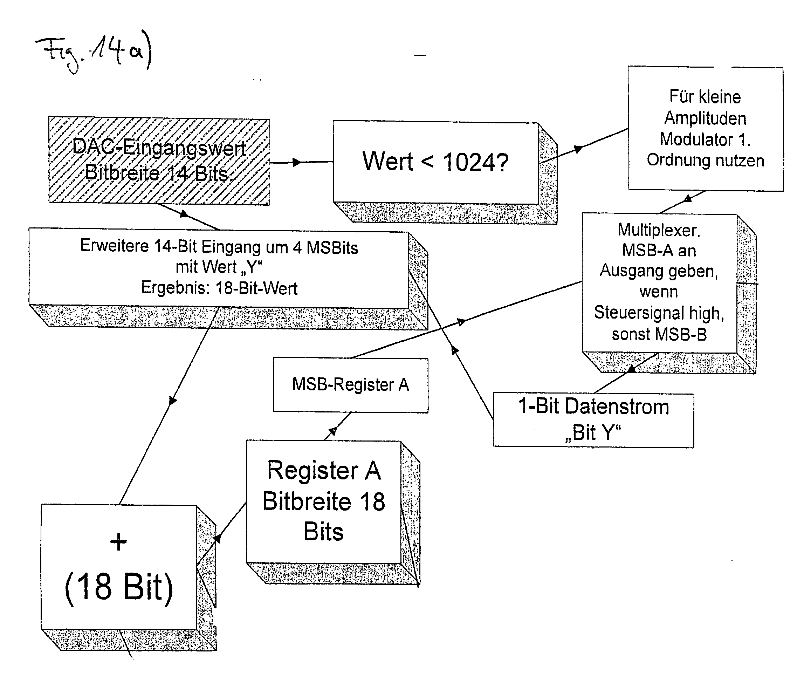

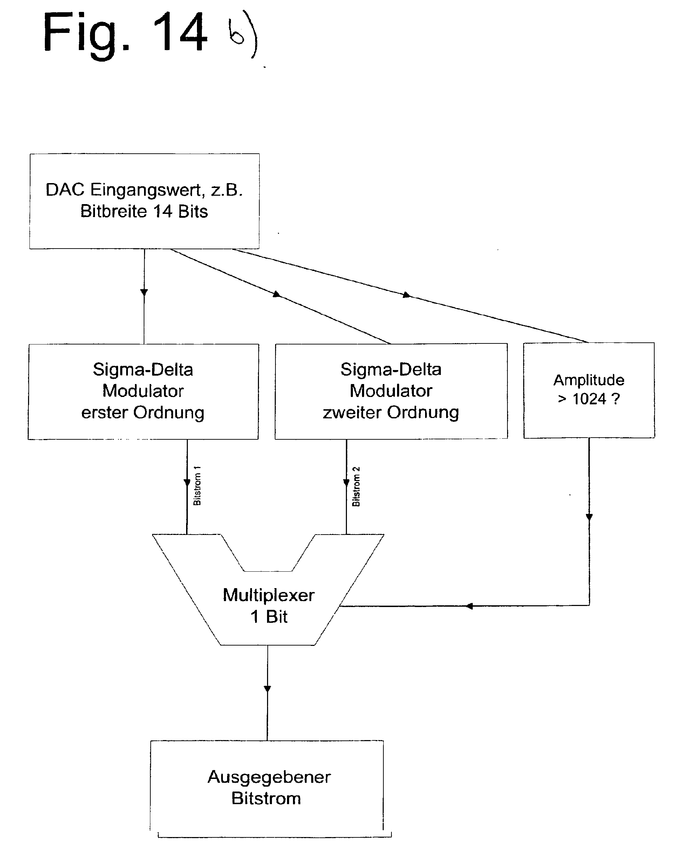

Figur 14 a) zeigt ein erstes Ablaufdiagramm eines Verfahrens zum Betreiben des digitalen Digital-Analog-Konverters. Der Eingangswert MOD_IN wird zunächst einer Fallunterscheidung unterzogen, um festzustellen, ob sein Wert einem niedrigen Ausgabewert des Stromsignals entspricht, bspw. kleiner 5 mA entspricht. Für kleine Amplituden wird dann ein Delta-Sigma-Modulator 1.Ordung genutzt bzw. in erster Ordnung betrieben. Liegt der Eingangswert über einem Schwellwert kann der digitale Digital-Analog-Konverter, in 2.ter Ordnung betrieben werden. Dafür kann der Eingangswert bspw. zunächst um vier MSBits erweitert werden.

Figur 14b) zeigt ein zweites Ablaufdiagramm des Verfahrens. Der Eingangswert MOD_IN wird an einen Sigma-Delta-Modulator erster Ordnung, einen Delta-Sigma-Modulator zweiter Ordnung und an eine Vergleichsschaltung, bspw. wie in Figur 14b) gezeigt parallel, übertragen. Das Ausgangssignal des Delta-Sigma-Modulators erster Ordnung und das Ausgangssignal des Delta-Sigma-Modulators zweiter Ordnung werden jeweils an die Eingänge eines Multiplexers geführt. Die Vergleichsschaltung, die wie erwähnt auch den Eingangswert MOD_IN erhält, gibt dann ein Schaltsignal aus, mittels welchem festgelegt wird, welcher der Eingänge des Multiplexers ausgewählt wird und zum Ausgang des Multiplexers durchgeschaltet wird. Die Vergleichsschaltung prüft dabei ob der Eingangswert MOD_IN größer oder kleiner als ein Schwellwert, hier z.B. 1024 ist.

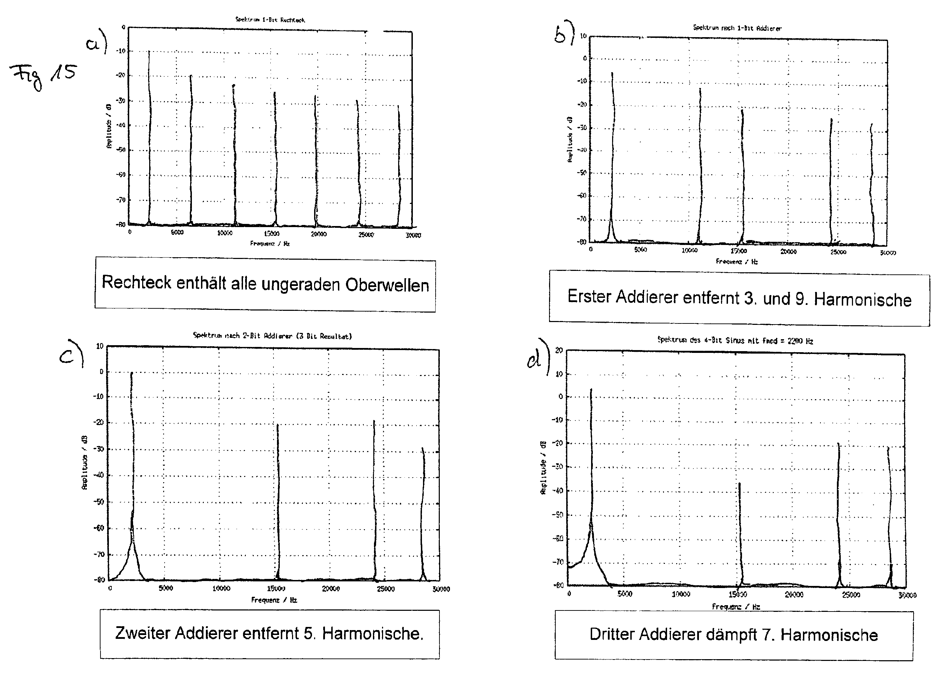

Figur 15 a), b), c), d) zeigt ein Spektrum des einzustellenden Wechselstromsignals während verschiedener Stadien der Erzeugung. In Figur 15 a) ist das Spektrum der 1-Bit Rechteck Funktion dargestellt. Das Spektrum enthält alle ungerade Oberschingungen. In Figur 15 b) zeigt das Spektrum nach dem ersten Addierer. Das Resultat des Addierers ist ein 2 Bit Signal. Durch die Addition kann die 3te und die 9te Oberschwingung insbesondere vollständig entfernt werden. Der zweite Addierer schließlich erzeugt ein 3 Bit Signal. Dessen Spektrum nun auch im Wesentlichen, insbesondere vollständig, frei von der 5.ten Oberschwingung ist und in Figur 15 c) dargestellt ist. In Figur 15 d) ist schließlich noch das Spektrum für den Fall eines 4 Bit Signals gezeigt, bei dem zusätzlich noch die 7te Oberschwingung gedämpft wird.

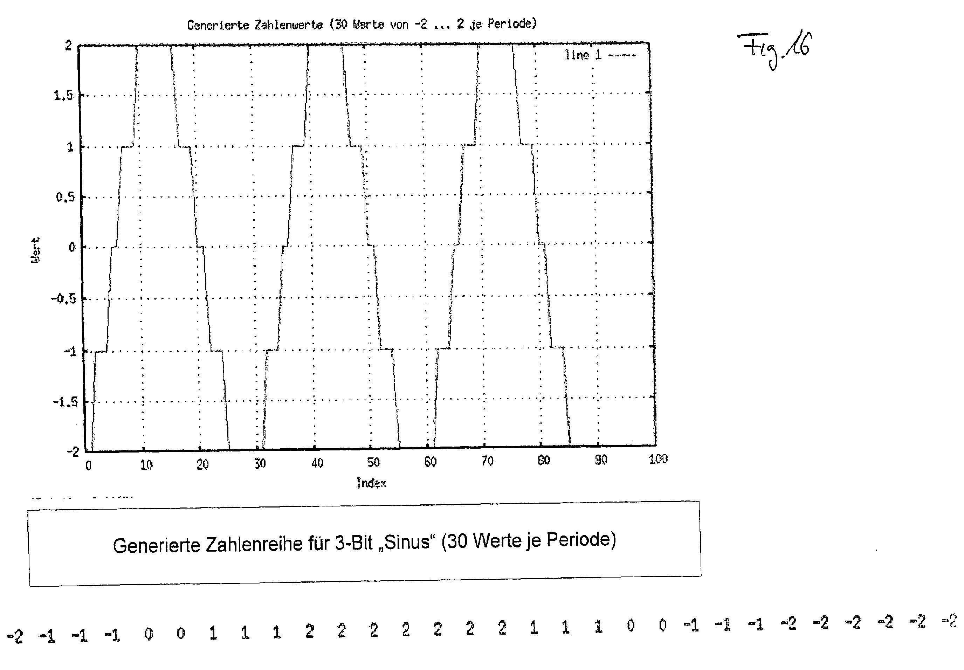

Figur 16 zeigt ein 3-Bit Sinussignal. Ein 3-Bit Signal kann sieben Werte annehmen. Fünf davon werden zur Erzeugung des Sinussignals bzw. der den Sinus repräsentierenden Zahlenreihe verwendet.

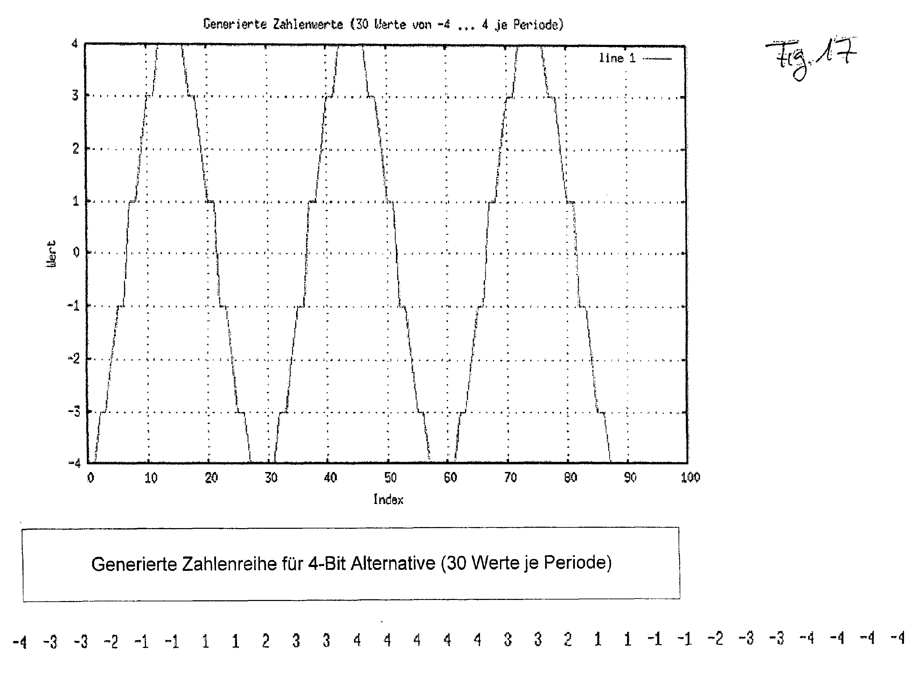

Figur 17 zeigt eine schematische Darstellung einer alternativen Ausgestaltung in Form eines 4-Bit Sinussignals. Das 4 Bit Signal setzt sich dabei aus einer Folge von Zahlenwerten zusammen, wobei ein Zahlenwert in einem Format mit der Bitbreite von 4 Bits dargestellt wird. Dabei ist es nicht relevant, ob der Zahlenwert über das in Fig. 12 gezeigte Schaltnetz generiert wird, oder z.B. über eine so genannte Lookup-Tabelle mit den in Fig. 16 und 17 gezeigten Zahlenwerten. Die Generierung über das Schaltnetz hat dabei jedoch den Vorteil, besonders wenige Logik-Ressourcen zu benötigen. Auch andere Zahlenreihen als in Tabelle 16 und 17 skizziert können ihren Zweck erfüllen, z.B. eine Zahlenreihe, welche auch die 7. Oberwelle vollständig dämpft. Dem liegt die Erkenntnis zugrunde, dass höhere Oberwellen für die Güte des an der Stromschleife erzeugten Sinus-Signals nicht wesentlich sind, und unter technischer Ausnutzung dieser Erkenntnis digitale Sinusgeneratoren genutzt werden können, welche einen Bruchteil der Gatter benötigen, als Sinusgeneratoren, welche auch Oberwellen größer als 7. Ordnung unterdrücken. Als Maß der relevanten Unterdrückung kann dabei angesetzt werden, dass alle Oberwellen der generierten 1.2 und 2.2 kHz Sinuswerte bis zur einschließlich 6. Ordnung um mindestens 30 dB gedämpft werden, mindestens eine Oberwelle 7. oder höherer Ordnung jedoch um einen Wert von weniger als 30 dB relativ zur Amplitude der Grundwelle gedämpft ist.

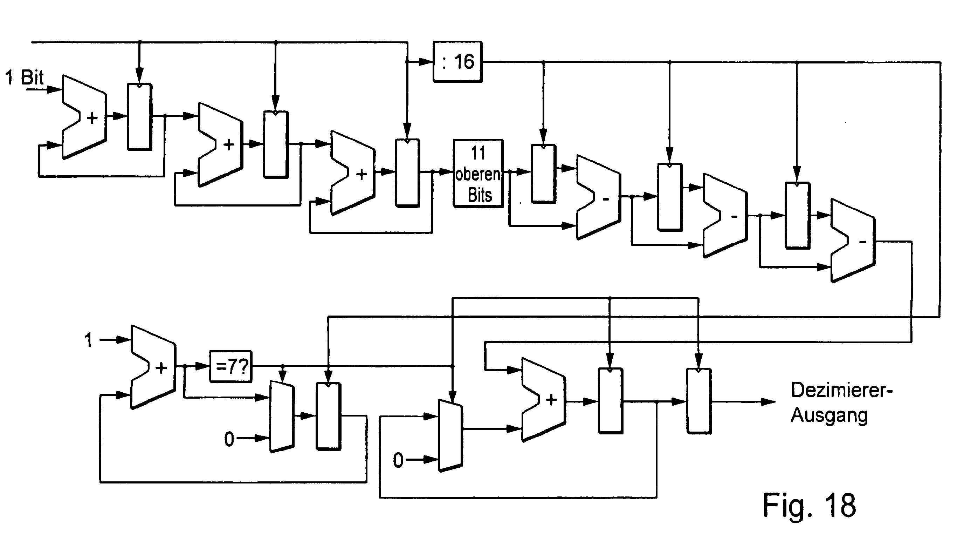

Figur 18 zeigt einen Dezimationsfilter. Nach dem Abtasten des in der Stromschleife eingestellten Stromsignals wird das abgetastete Signal in einem ersten Schritt in einem Dezimationsfilter weiterverarbeitet. Dabei wird bspw. die Abtastfrequenz reduziert. Dafür kann bspw. wie in Figur 18 gezeigt ein Cascaded-Integral-Comb-Filter, kurz CIC-Filter, verwendet werden. Das Abtasten des Stromsignals in der Stromschleife kann dabei bspw. mittels eines analogen Delta-Sigma-Modulators erfolgen.

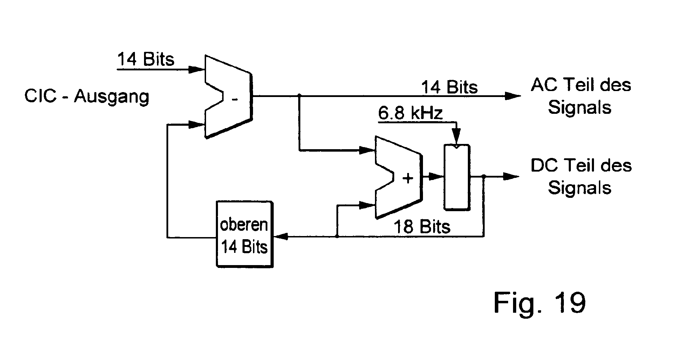

Figur 19 zeigt eine schematische Darstellung einer Schaltung zur Trennung des Gleichstrom- und Wechselstromanteils aus dem zweiten Datenstrom. Das Gleichstromsignal wird von dem Wechselstromsignal getrennt. Dafür kann bspw. ein Moving-Average-Filter verwendet werden. Als Eingangssignal dient hier das von dem CIC-Filter ausgegebene Signal.

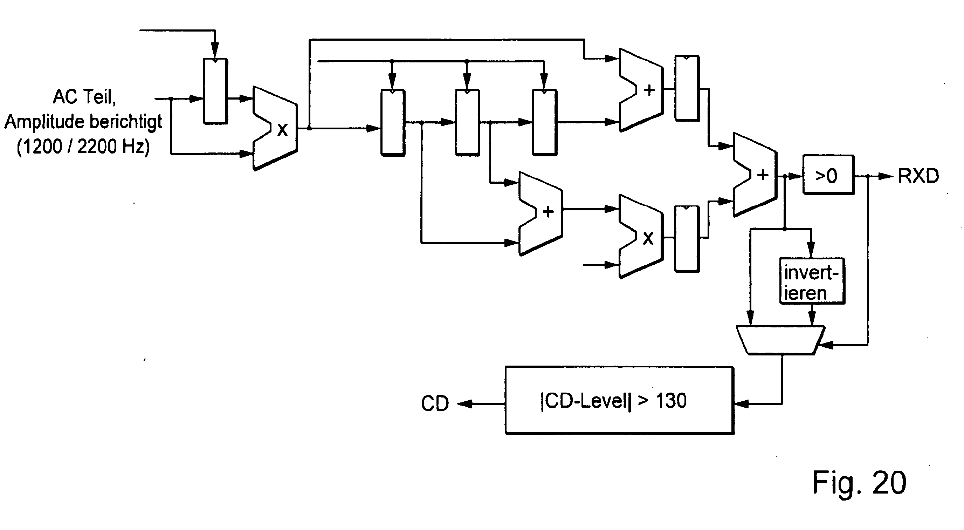

Figur 20 zeigt eine schematische Darstellung einer Schaltung zur Generierung eines CD- und eines RxD-Signals. Das Wechselstromsignal wird in das RxD und das Carrier Detect Signal gewandelt. RxD und Carrier Detect werden dann wieder an die Steuereinheit zurückübertragen.

**Bezugszeichenliste**

| | |
|---|---|
| S1 | Erstes System |
| S2 | Zweites System |
| L | Zweileiter-Stromschleife |
| AB | Erster Frequenzbereich des Gleichstromsignals |
| DB | Zweiter Frequenzbereich des Wechselstromsignals |
| E | Energie |
| F | Frequenz |
| CPU | Steuereinheit |
| DAC | Digital-Analog-Wandler |
| ADC | Analog-Digital-Wandler |
| HART-MODEM | HART MODEM |
| B1 | Erster Bandpassfilter |
| B2 | Zweiter Bandpassfilter |
| K | Wechselstromkopplung |
| AS | Anschluss Stromschleife |
| SSW | Spannungs-Strom-Wandler |
| R1 | Erstes Register |
| R2 | Zweites Register |
| ADD | Addierer |
| DM | Digitaler Delta-Sigma-Modulator |
| AM | Analoger Delta-Sigma-Modulator |
| F | Erster Filter |
| Sensor | Messaufnehmer/Sensor |
| DI | Dezimationsfilter |
| DF | Digitaler Filter |
| CLK | Takt |
| GND | Masse |
| VCC | Versorgungseingang |
| Q15 | Transistor |
| REF | Versorgungsspannung |
| LM2 | Operationsverstärker |
| LM3 | Komparator |
| LM4 | Operationsverstärker |
| GB | Galvanische Barriere |
| FL | Flip-Flop |
| M2 | Feldeffekttransistor |
| Q15 | Transistor |
| L+ | Positiver Stromschleifenanschluss |
| L- | Negativer Stromschleifenanschluss |
| PS | Spannungsversorgung |
| REF | Referenzspannung |
| PS2 | Versorgungsspannung für Operationsverstärker |
| PS3 | Versorgungsspannung für Operationsverstärker |
| PS4 | Versorgungsspannung für Operationsverstärker |
| U1 | Erster Datenstrom |
| U2 | Zweiter Datenstrom |
| U3 | Taktsignal |
| G | Wächterring |
| US | Shuntspannung |
| R46 | Shuntwiderstand |
| R | Register |
| S | Stromausgangsschaltung |
| A1 | Erstes Steuersignal |
| A2 | Zweites Steuersignal |
| C24 | Erster Glättungskondensator |
| C25 | Zweiter Glättungskondensator |
| C26 | Dritter Glättungskondensator |
| C23 | Vierter Glättungskondensator |
| C22 | Kondensator |
| R64 | Erster Widerstand |
| R63 | Zweiter Widerstand |
| R62 | Dritter Widerstand |
| R61 | Vierter Widerstand |
| R53 | Fünfter Widerstand |
| C22 | Erster Kondensator |
| C32 | Zweiter Kondensator |
| C31 | Dritter Kondensator |
| C29 | Vierter Kondensator |
| C28 | Fünfter Kondensator |
| R30 | Sechster Widerstand |
| C27 | Sechster Kondensator |
| C5 | Siebter Kondensator |
| R23 | Siebter Widerstand |
| C4 | Achter Kondensator |
| R13 | Achter Widerstand |
| R44 | Neunter Widerstand |
| C20 | Neunter Kondensator |
| R25 | Zehnter Widerstand |
| R28 | Elfter Widerstand |
| C19 | Zehnter Kondensator |
| R40 | Zwölfter Widerstand |
| C21 | Elfter Kondensator |
| R41 | Dreizehnter Widerstand |
| R12 | Vierzehnter Widerstand |
| R51 | Fünfzehnter Widerstand |
| R49 | Sechzehnter Widerstand |
| R50 | Siebzehnter Widerstand |
| R48 | Achtzehnter Widerstand |

## Patentansprüche

1. Verfahren zur Signalübertragung zwischen einem ersten und einem zweiten System (S1, S2), wobei das erste und das zweite System (S1, S2) über eine Stromschleife (L) miteinander in Verbindung stehen,
wobei ein Gleichstromsignal in einem ersten Frequenzbereich (AB) und ein Wechselstromsignal in einem zweiten Frequenzbereich (DB) über die Stromschleife (L) übertragen werden,
wobei sich das Gleichstromsignal und das Wechselstromsignal überlagern,
wobei das Wechselstromsignal zur digitalen Signalübertragung und das Gleichstromsignal zur analogen Signalübertragung verwendet werden,
**dadurch gekennzeichnet,**
**dass** mittels einer Steuereinheit (CPU) ein erster Datenstrom (U1) erzeugt wird,
in welchem das in der Stromschleife (L) einzustellende Gleichstromsignal und Wechselstromsignal digital verschlüsselt sind,
**dass** der erste Datenstrom (U1) an eine Stromausgangsschaltung (S) übermittelt wird,
**dass** der übermittelte erste Datenstrom (U1) von der Stromausgangsschaltung in ein Stromsignal umgesetzt wird, welches Stromsignal aus dem sich überlagernden Gleichstromsignal und Wechselstromsignal besteht, oder
**dass** der übermittelte erste Datenstrom (U1) von der Stromausgangsschaltung (S) in das Gleichstromsignal und das Wechselstromsignal umgesetzt wird,
und **dass** das Stromsignal bzw. das Gleichstromsignal und das Wechselstromsignal in der Stromschleife (L) eingestellt werden.

2. Verfahren zur Signalübertragung nach Anspruch 1,
**dadurch gekennzeichnet,**
**dass** wenigstens ein erstes Steuersignal von der Steuereinheit erzeugt wird, in welchem das in der Stromschleife einzustellende Wechselstromsignal digital verschlüsselt ist, und
**dass** wenigstens ein zweites Steuersignal von der Steuereinheit erzeugt wird, in welchem das in der Stromschleife einzustellende Gleichstromsignal digital verschlüsselt ist.

3. Verfahren zur Signalübertragung nach Anspruch 2,
**dadurch gekennzeichnet,**
**dass** mittels des ersten Steuersignals mindestens ein Zahlenwert erzeugt wird, der dem einzustellenden Wechselstromsignal entspricht.

4. Verfahren zur Signalübertragung nach Anspruch 2,
**dadurch gekennzeichnet,**
**dass** mittels des ersten Steuersignals eine Folge von Zahlenwerten erzeugt wird, wobei die Folge dem einzustellenden Wechselstromsignal entspricht.

5. Verfahren zur Signalübertragung nach Anspruch 3,
**dadurch gekennzeichnet,**
**dass** der Zahlenwert bzw. einzelne Zahlenwerte der Folge in einem Format mit einer Bitbreite von n Bits erzeugt werden,
wobei n eine natürliche Zahl, insbesondere drei oder vier, ist.

6. Verfahren zur Signalübertragung nach einem der Ansprüche 2 bis 5,
**dadurch gekennzeichnet,**
**dass** mittels des zweiten Steuersignals ein dem einzustellenden Gleichstromsignal entsprechender Zahlenwert, insbesondere mit einer Bitbreite von weniger als m Bits, erzeugt wird, wobei m eine natürliche Zahl ist.

7. Verfahren zur Signalübertragung nach dem vorherigen Anspruch,
**dadurch gekennzeichnet,**
**dass** mindestens ein Zahlenwert der Folge, welcher das Wechselstromsignal repräsentiert, insbesondere auf die Bitbreite des Zahlenwerts des Gleichstromsignals, skaliert wird.

8. Verfahren zur Signalübertragung nach einem der Ansprüche 6 oder 7,
**dadurch gekennzeichnet,**
**dass** wenigstens ein Zahlenwert der Folge, welche das Wechselstromsignal repräsentiert, und der Zahlenwert des einzustellenden Gleichstromsignals zusammengefasst, insbesondere addiert, werden und in den ersten Datenstrom umgesetzt werden.

9. Verfahren zur Signalübertragung nach Anspruch 8,
**dadurch gekennzeichnet,**
**dass** die Umsetzung mittels eines digitalen Delta-Sigma-Modulators durchgeführt wird,
**dass** der digitale Delta-Sigma-Modulator abhängig von einem Eingangswert betrieben wird, welcher Eingangswert von dem einzustellenden Gleichstromsignal und/oder Wechselstromsignal abhängig ist,
welcher Eingangswert insbesondere aus wenigstens einem Zahlenwert der Folge, die dem einzustellenden Wechselstromsignal entspricht und/oder dem Zahlenwert des einzustellenden Gleichstromsignals abgeleitet wird, in erster oder zweiter Ordnung betrieben wird.

10. Verfahren zur Signalübertragung nach einem der vorherigen Ansprüche,
**dadurch gekennzeichnet,**
**dass** das in der Stromschleife (L) eingestellte Gleichstromsignal und Wechselstromsignal in einen zweiten Datenstrom (U2) umgewandelt werden,
in welchem zweiten Datenstrom (U2) das Gleichstromsignal und das Wechselstromsignal digital verschlüsselt sind,
und **dass** der zweite Datenstrom (U2) von der Stromausgangsschaltung (S) an die Steuereinheit (CPU) rückübermittelt wird.

11. Verfahren zur Signalübertragung nach einem der vorherigen Ansprüche,
**dadurch gekennzeichnet,**
**dass** das in der Stromschleife eingestellte und sich überlagernde Gleichstrom- und Wechselstromsignal abgetastet und in einen zweiten Datenstrom umgewandelt wird.

12. Verfahren zur Signalübertragung nach dem vorherigen Anspruch,
**dadurch gekennzeichnet,**
**dass** die Abtastrate des zweiten Datenstroms, insbesondere mittels eines Dezimationsfilters, verringert wird

13. Verfahren zur Signalübertragung nach dem vorherigen Anspruch,
**dadurch gekennzeichnet,**
**dass** aus dem, insbesondere dezimierten, zweiten Datenstrom ein erster Zahlenwert ermittelt wird, der das in der Stromschleife eingestellte Gleichstrom- und Wechselstromsignal repräsentiert.

14. Verfahren zur Signalübertragung nach dem vorherigen Anspruch,
**dadurch gekennzeichnet,**
**dass** aus dem ersten Zahlenwert ein zweiter Zahlenwert abgeleitet wird, der dem in der Stromschleife eingestellten Gleichstromsignal entspricht, und
**dass** aus dem ersten Zahlenwert ein dritter Zahlenwert abgeleitet wird, der dem in der Stromschleife eingestellten Wechselstromsignal entspricht.

15. Verfahren zur Signalübertragung nach dem vorherigen Anspruch,
**dadurch gekennzeichnet,**
**dass** eine Frequenzgangkorrektur des abgetasteten, insbesondere dezimierten, Gleichstrom - und/oder Wechselstromsignals durchgeführt wird.

16. Elektrische und/oder elektronische Schaltung zur Signalübertragung zwischen einem ersten und einem zweiten System (S1, S2),
wobei das erste und das zweite System (S1, S2) über eine Stromschleife (L) miteinander in Verbindung stehen,
wobei die Stromschleife (L) dazu dient,
in einem ersten Frequenzbereich (AB) ein Gleichstromsignal und in einem zweiten Frequenzbereich (DB) ein Wechselstromsignal zu übertragen,
wobei sich das Wechselstromsignal und das Gleichstromsignal überlagern,
wobei das Gleichstromsignal zur analogen Signalübertragung
und das Wechselstromsignal zur digitalen Signalübertragung dient,
**dadurch gekennzeichnet,**
**dass** eine Steuereinheit (CPU) vorgesehen ist,
welche zur Erzeugung eines ersten Datenstroms (U1) dient,
in welchem ersten Datenstrom (U1) das in der Stromschleife (L) einzustellende Gleichstromsignal und Wechselstromsignal digital verschlüsselt sind,
**dass** eine erste Übermittlungseinheit vorgesehen ist, welche dazu dient,
den ersten Datenstrom (U1) an eine Stromausgangsschaltung (S) zu übermitteln,
und **dass** die Stromausgangsschaltung (S) dazu dient, den übermittelten ersten Datenstrom (U1) in ein Stromsignal umzusetzen, welches Stromsignal aus dem sich überlagernden Gleichstromsignal und Wechselstromsignal besteht,
oder dass die Stromausgangsschaltung (S) dazu dient, den übermittelten ersten Datenstrom (U1) in das Gleichstromsignal und das Wechselstromsignal umzusetzen.

17. Feldgerät der Prozess- und/oder Automatisierungstechnik mit einer elektrischen und/oder elektronischen Schaltung nach Anspruch 16.

## Claims

1. Procedure designed to transmit signals between a first and a second system (S1, S2), wherein the first and the second system (S1, S2) are connected to one another via a current loop (L),
wherein a direct current signal is transmitted via the current loop (L) in a first frequency range (AB) and an alternating current signal is transmitted via the current loop (L) in a second frequency range,
wherein the direct current signal and the alternating current signal are superimposed on one another,
wherein the alternating current signal is used for digital signal transmission and the direct current signal is used for analog signal transmission,
**characterized in that**
via a central processing unit (CPU) a first data stream (U1) is generated in which the direct current signal and the alternating current signal to be set in the current loop (L) are digitally encrypted,
**in that** the first data stream (U 1) is transmitted to a current output circuit (S),
**in that** the current output circuit converts the transmitted first data stream (U1) into a current signal, said current signal consisting of the direct current signal and the alternating current signal that are superimposed on one another, or
**in that** the current output circuit (S) converts the transmitted first data stream (U1) into the direct current signal and the alternating current signal,
and **in that** the current signal and/or the direct current signal and the alternating current signal are set in the current loop (L).

2. Procedure designed for signal transmission as claimed in Claim 1,
**characterized in that**
the control unit generates at least a first control signal in which the alternating current signal to be set in the current loop is digitally encrypted, and
**in that** the control unit generates at least a second control signal in which the direct current signal to be set in the current loop is digitally encrypted.

3. Procedure designed for signal transmission as claimed in Claim 2,
**characterized in that**
at least one numerical value, which corresponds to the alternating current signal to be set, is generated with the first control signal.

4. Procedure designed for signal transmission as claimed in Claim 2,
**characterized in that**
a series of numerical values is generated with the first control signal, wherein the order corresponds to the alternating current signal to be set.

5. Procedure designed for signal transmission as claimed in Claim 3,
**characterized in that**
the numerical value or individual numerical values of the series are generated in a format with a bit width of n bits,
with n being a natural number, particularly three or four.

6. Procedure designed for signal transmission as claimed in one of the Claims 2 to 5,
**characterized in that**
the second control signal is used to generate a numerical value, which corresponds to the direct current signal to be set, particularly a numerical value with a bit width of fewer than m bits, with m being a natural number.

7. Procedure designed for signal transmission as claimed in the previous claim,
**characterized in that**
at least one numerical value of the series that represents the alternating current signal is scaled particularly to the bit width of the numerical value of the direct current signal.

8. Procedure designed for signal transmission as claimed in one of the Claims 6 or 7,
**characterized in that**
at least one numerical value of the series that represents the alternating current signal and the numerical value of the direct current signal to be set are grouped together, in particular added together, and are converted into the first data stream.

9. Procedure designed for signal transmission as claimed in Claim 8,
**characterized in that**
the conversion is performed using a digital delta-sigma modulator,
**in that** the digital delta-sigma modulator is operated as a function of an input value, said input value being dependent on the direct current signal and/or the alternating current signal to be set,
said input value being operated in first or second order and made up of at least one numerical value of the series which corresponds to the alternating current signal to be set, and/or is derived from the numerical value of the direct current signal to be set.

10. Procedure designed for signal transmission as claimed in one of the previous claims,
**characterized in that**
the direct current signal and the alternating current signal set in the current loop (L) are converted into a second data stream (U2),
in said second data stream (U2) the direct current signal and the alternating current signal are digitally encrypted,
and **in that** the second data stream (U2) is relayed back by the current output circuit (S) to the central processing unit (CPU).

11. Procedure designed for signal transmission as claimed in one of the previous claims,
**characterized in that**
the direct current signal and alternating current signal that are superimposed on one another and set in the current loop are scanned and converted into the second data stream.

12. Procedure designed for signal transmission as claimed in the previous claim,
**characterized in that**
the scan rate of the second data stream is reduced, particularly by using a decimation filter.

13. Procedure designed for signal transmission as claimed in the previous claim,
**characterized in that**
a first numerical value is determined from the second, particularly decimated, data stream, said numerical value representing the direct current signal and the alternating current signal set in the current loop.

14. Procedure designed for signal transmission as claimed in the previous claim,
**characterized in that**
a second numerical value is derived from the first numerical value, wherein the second numerical value corresponds to the direct current signal set in the current loop, and a third numerical value is derived from the first numerical value, wherein the third numerical value corresponds to the alternating current signal set in the current loop.

15. Procedure designed for signal transmission as claimed in the previous claim,
**characterized in that**
a frequency response correction is performed on the scanned, and particularly decimated, direct current and/or alternating current signal.

16. Electrical and/or electronic circuit for signal transmission between a first and second system (S1, S2),
wherein the first and second system (S1, S2) are connected to one another via a current loop (L),
wherein said current loop (L) serves to
transmit a direct current signal in a first frequency range (AB), and an alternating current signal in a second frequency range (DB),
wherein the alternating current signal and the direct current signal are superimposed,
wherein the direct current signal is used for analog signal transmission and the alternating current signal is used for digital signal transmission,
**characterized in that**
a central processing unit (CPU) is provided,
said CPU being used to generate a first data stream (U1),
in said first data stream (U1), the direct current signal and the alternating current signal to be set in the current loop (L) are digitally encrypted,
a first transmission unit is provided that is used to transmit the first data stream (U1) to a current output circuit (S),
and **in that** the current output circuit (S) serves to convert the transmitted first data stream (U1) to a current signal, said current signal consisting of direct current signal and alternating current signal that are superimposed on one another,
or **in that** the current output circuit (S) is used to convert the transmitted first data stream (U1) to the direct current signal and the alternating current signal.

17. Field device used in process and/or automation engineering with an electrical and/or electronic circuit as claimed in Claim 16.

## Revendications

1. Procédé destiné à la transmission de signaux entre un premier et un deuxième système (S1, S2),
le premier et le deuxième systèmes (S1, S2) étant reliés entre eux par l'intermédiaire d'une boucle de courant (L),
pour lequel un signal de courant continu est transmis dans une première plage de fréquence (AB) et un signal de courant alternatif dans une deuxième plage de fréquence (DB) par l'intermédiaire de la boucle de courant (L),
pour lequel le signal de courant continu et le signal de courant alternatif sont superposés, pour lequel le signal de courant alternatif est utilisé pour la transmission de signaux numériques et le signal de courant continu pour la transmission de signaux analogiques,
**caractérisé en ce**
**qu'**est généré un flux de données (U1) au moyen d'une unité de commande (CPU), dans lequel le signal de courant continu et le signal de courant alternatif à régler dans la boucle de courant (L) sont codés numériquement,
**que** le premier flux de données (U1) est transmis à un circuit de sortie courant (S),
**que** le premier flux de données (U 1) transmis par le circuit de sortie courant est converti en un signal de courant, lequel signal de courant se compose du signal de courant continu et du signal de courant alternatif superposés, ou
**que** le premier flux de données (U1) transmis par le circuit de sortie courant (S) est converti en le signal de courant continu et le signal de courant alternatif,
et en ce que le signal de courant ou le signal de courant continu et le signal de courant alternatif sont réglés dans la boucle de courant (L).

2. Procédé destiné à la transmission de signaux selon la revendication 1,
**caractérisé en ce**
**qu'**est généré au moins un premier signal de commande par l'unité de commande, signal dans lequel le signal de courant alternatif à régler dans la boucle de courant est codé numériquement, et
**qu'**est généré au moins un deuxième signal de commande par l'unité de commande, signal dans lequel le signal de courant continu à régler dans la boucle de courant est codé numériquement.

3. Procédé destiné à la transmission de signaux selon la revendication 2,
**caractérisé en ce**
**qu'**est générée, au moyen du premier signal de commande, une valeur numérique, qui correspond au signal de courant alternatif à régler.

4. Procédé destiné à la transmission de signaux selon la revendication 2,
**caractérisé en ce**
**qu'**est générée, au moyen du premier signal de commande, une suite de valeurs numériques, la suite correspondant au signal de courant alternatif à régler.

5. Procédé destiné à la transmission de signaux selon la revendication 3,
**caractérisé en ce**
**que** la valeur numérique ou les différentes valeurs numériques de la suite sont générées dans un format avec une largeur de n bits,
n étant un nombre naturel, notamment trois ou quatre.

6. Procédé destiné à la transmission de signaux selon l'une des revendications 2 à 5,
**caractérisé en ce**
**qu'**est générée, au moyen du deuxième signal de commande, une valeur numérique correspondant au signal de courant continu à régler, valeur notamment avec une largeur de bit inférieure à m bits, m étant un nombre naturel.

7. Procédé destiné à la transmission de signaux selon la revendication précédente,
**caractérisé en ce**
**qu'**au moins une valeur numérique de la suite, laquelle représente le signal de courant alternatif, est cadrée notamment par rapport à la largeur de bit de la valeur numérique du signal de courant continu.

8. Procédé destiné à la transmission de signaux selon l'une des revendications 6 ou 7,
**caractérisé en ce**
**qu'**au moins une valeur numérique de la suite, laquelle représente le signal de courant alternatif, et la valeur numérique du signal de courant continu à régler sont regroupées, notamment additionnées, et converties en le premier flux de données.

9. Procédé destiné à la transmission de signaux selon la revendication 8,
**caractérisé en ce**
**que** la conversion est réalisée au moyen d'un modulateur delta-sigma numérique, que le modulateur delta-sigma est utilisé en fonction d'une valeur d'entrée, laquelle valeur d'entrée dépend du signal de courant continu et/ou du signal de courant alternatif à régler.

10. Procédé destiné à la transmission de signaux selon l'une des revendications précédentes,
**caractérisé en ce**
**que** le signal de courant continu et le signal de courant alternatif, réglés dans la boucle de courant (L), sont convertis en un deuxième flux de données (U2),
dans lequel deuxième flux de données (U2) le signal de courant continu et le signal de courant alternatif sont codés numériquement,
et en ce que le deuxième flux de données (U2) est retransmis depuis le circuit de sortie courant (S) à l'unité de commande (CPU).

11. Procédé destiné à la transmission de signaux selon l'une des revendications précédentes,
**caractérisé en ce**
**que** le signal de courant continu et le signal de courant alternatif superposés, réglés dans la boucle de courant, sont échantillonnés et convertis en un deuxième flux de données.

12. Procédé destiné à la transmission de signaux selon la revendication précédente, **caractérisé en ce**
**que** le taux d'échantillonnage du deuxième flux de données est diminué, notamment au moyen d'un filtre de décimation.

13. Procédé destiné à la transmission de signaux selon la revendication précédente,
**caractérisé en ce**
**qu'**est déterminée une première valeur numérique à partir du deuxième flux de données, notamment décimé, laquelle valeur représente le signal de courant continu et de courant alternatif réglé dans la boucle de courant.

14. Procédé destiné à la transmission de signaux selon la revendication précédente,
**caractérisé en ce**
**qu'**est dérivée à partir de la première valeur numérique une deuxième valeur numérique, qui correspond au signal de courant continu réglé dans la boucle de courant, et
**qu'**est dérivée à partir de la première valeur numérique une troisième valeur numérique, qui correspond au signal de courant alternatif réglé dans la boucle de courant.

15. Procédé destiné à la transmission de signaux selon la revendication précédente,
**caractérisé en ce**
**qu'**est réalisée une correction de la réponse en fréquence du signal de courant continu et/ou de courant alternatif échantillonné, notamment décimé.

16. Circuit électrique et/ou électronique destiné à la transmission de signaux entre un premier et un deuxième système (S1, S2),
pour lequel le premier et le deuxième systèmes (S1, S2) sont reliés entre eux par l'intermédiaire d'une boucle de courant (L),
pour lequel la boucle de courant (L) sert à
transmettre, dans une première plage de fréquence (AB), un signal de courant continu et, dans une deuxième plage de fréquence (DB), un signal de courant alternatif,
pour lequel le signal de courant alternatif et le signal de courant continu sont superposés, pour lequel le signal de courant continu sert à la transmission de signaux analogiques et le signal de courant alternatif sert à la transmission de signaux numériques,
**caractérisé en ce**
**qu'**est prévue une unité de commande (CPU),
laquelle sert à la génération d'un premier flux de données (U1),
dans lequel premier flux de données (U1) sont codés numériquement le signal de courant continu et le signal de courant alternatif à régler dans la boucle de courant (L), qu'est prévue une première unité de transmission, laquelle sert à transmettre le premier flux de données (U1) à un circuit de sortie courant (S),
et en ce que le circuit de sortie courant (S) sert à convertir le premier flux de données (U1) transmis en un signal de courant, lequel signal de courant se compose du signal de courant continu et du signal de courant alternatif superposés,
ou en ce que le circuit de sortie courant (S) sert à convertir le flux de données (U1) transmis en le signal de courant continu et le signal de courant alternatif.

17. Appareil de terrain de la technique de process et/ou d'automatisation avec un circuit électrique et/ou électronique selon la revendication 16.
